# NEW EUROPEAN PATENT SPECIFICATION

(11) **EP 1 967 598 B2**
(45) Date of publication and mention of the opposition decision: **25.11.2015**
(45) Mention of the grant of the patent: 16.06.2010
(21) Application number: 08157601.9
(22) Date of filing: 26.03.2002
(51) Int. Cl.: C30B 25/18, C30B 29/02, C22C 21/08, C22F 1/043, C22F 1/047, C22C 21/02, C22C 21/06, C22F 1/05

(54) **Aluminum alloy sheet with excellent formability and paint bake hardenability and method for production thereof**
Aluminium-Legierungsblech mit ausgezeichneter Formbarkeit und Brennhärtbarkeit, sowie Herstellungsverfahren dafür
Feuille d'alliage d'aluminium dotée d'excellentes formabilité et trempabilité par cuisson de peinture et procédé pour sa production

(30) Priority: 28.03.2001 JP 2001091979; 28.03.2001 JP 2001091980; 27.09.2001 JP 2001295633; 08.03.2002 JP 2002063118; 08.03.2002 JP 2002063119; 20.03.2002 JP 2002077794; 20.03.2002 JP 2002077795
(43) Date of publication of application: 10.09.2008
(62) Divisional of application: 02705498.0
(73) Proprietor: Sumitomo Light Metal Industries, Ltd., Minato-ku Tokyo 105-8601 (JP)
(72) Inventor: Uchida, Hidetoshi, Minato-ku Tokyo Tokyo 105-8601 (JP); Minoda, Tadashi, Minato-ku Tokyo Tokyo 105-8601 (JP); Asano, Mineo, Minato-ku Tokyo Tokyo 105-8601 (JP); Ozeki, Yoshikazu, Minato-ku Tokyo Tokyo 105-8601 (JP); Furuyama, Tsutomu, Minato-ku Tokyo Tokyo 105-8601 (JP)
(74) Representative: Schwabe - Sandmair - Marx

(56) References cited:
- WO-A-00/52219
- WO-A-98/35069
- INOUE, HIROFUMI ET AL: "Estimation of r - value in aluminum alloy sheets by quantitative texture analysis" KEIKINZOKU , 44(2), 97-103 CODEN: KEIKA6; ISSN: 0451-5994, 1994, XP009103620
- KO, HUNG-SUK ET AL: "A study on the texture and plastic anisotropy of aluminum alloys for auto body application" TAEHAN KUMSOK HAKHOECHI , 35(12), 1699-1709 CODEN: TKHCDJ; ISSN: 0253-3847, 1997, XP009103601
- JINTA M ET AL: "Press forming analysis of aluminum auto body panel: wrinkle behavior in 5000 and 6000 series aluminum alloy sheet forming" JSAE REVIEW, SOCIETY OF AUTOMOTIVE ENGINEERS OF JAPAN, TOKYO, JP, vol. 21, no. 3, 1 January 2000 (2000-01-01), pages 407-409, XP009103624 ISSN: 0389-4304
- HUFNAGEL W: "Key to Aluminium Alloys, 4th Edition" ALUMINIUM-SCHLUESSEL = KEY TO ALUMINIUM ALLOYS, XX, XX, 1991, pages 195-205, XP002194851

## Description

### TECHNICAL FIELD

The present invention relates to an aluminum alloy sheet with excellent formability and paint bake hardenability and suitable as a material for transportation parts, in particular, as an automotive outer panel, and a method for producing the same.

### BACKGROUND ART

An automotive outer panel is required to have 1) formability, 2) shape fixability (shape of the press die is precisely transferred to the material by press working), 3) dent resistance, 4) corrosion resistance, 5) surface quality, and the like. Conventionally, 5000 series (Al-Mg) aluminum alloys and 6000 series (Al-Mg-Si) aluminum alloys have been applied to the automotive outer panel. The 6000 series aluminum alloy has attracted attention because high strength is obtained due to excellent paint bake hardenability, whereby further gage dawn and weight saving is expected. Therefore, various improvement have been made on the 6000 series aluminum alloy.

Among the properties required for the automotive outer panel, although the shape fixability prefer lower yield strength, the dent prefer higher yield strength. In order to solve this problem, press working are carried out lower yield strength for shape fixability and dent resistance are improved by excellent paint bake hardenability using 6000 series aluminum alloy (see JP. 5-247610, JP. 5-279822, JP. 6-17208, etc.).

The 6000 series aluminum alloy has problems relating to the surface quality after forming, such as occurrence of orange peel surfaces and ridging marks (long streak-shaped defects occurring in the rolling direction during plastic working). Surface quality defects can be solved by adjusting the alloy components, managing the production conditions, and the like. For example, a method of preventing formation of coarse precipitates by homogenizing the alloy at a temperature of 500°C or more, cooling the homogenized product to 450-350°C, and starting hot rolling in this temperature range has been proposed in order to prevent occurrenceofridgingmarks (see JP. 7-228956). However, if the cooling rate is decreased when cooling the homogenized product from the homogenization temperature of 500°C or more to the hot rolling temperature of 450°C, coarse Mg-Si compounds are formed. This makes it necessary to perform a solution treatment at a high temperature for a long time in the subsequent step, whereby production efficiency is decreased.

In the case of assembling an outer panel an inner panel material, 180° bending (flat hemming), in which working conditions are severe since the ratio (R/t) of the center bending radius (R) to the sheet thickness (t) is small, is performed. However, since the 6000 series aluminum alloy has inferior bendability in comparison with the 5000 series aluminum alloy, flat hemming can not be performed in high press working area.

WO 00/52219 discloses a method of converting an ingot of a 6000 series aluminium alloy to self-annealing sheet, which comprises subjecting the ingot to a two-stage homogenisation treatment, first at at least 560 °C and then at 450 °C to 480 °C, then hot rolling the homogenised ingot at a starting hot roll temperature of 450 °C to 480 °C and a finishing hot roll temperature of 320 °C to 360°C. The resulting hot rolled sheet has an unusually low CUBE recrystallisation component. The preferred alloy composition comprises in wt %: Si 0.9 to 1.3, Fe 0.15 to 0.4, Mg 0.35 to 0.5, Cu up to 0.2, Mn 0.04 to 0.1, Cr 0.01 to 0.15, others up to 0.05 each and 0.15 in total and the balance consisting of Al. Further information concerning this technical field can be obtained by the publications "Estimation of r-value in aluminum alloy sheets by quantitative texture analysis" by INOUE, HIROFUMI ET AL; KEIKINZOKU, 44(2), 97-103 CODEN: KEIKA6; ISSN: 0451-5994, 1994, XP009103620 and "A study on the texture and plastic anisotropy of aluminum alloy for auto body application" by KO, HUNG-SUH ET AL; TAEHAN KUMSOK HAKHOECHI, 35(12), 1699-1709 CODEN: TKHCDJ; ISSN: 0253-3847. 1977, XP009103601.

### DISCLOSURE OF THE INVENTION

The present inventors have examined for further improving formability, in particular, bendability of the 6000 series aluminum alloy. As a result, it has been found that bendability of the 6000 series alloy is affected by the precipitation state of Mg-Sicompounds and misorientation of adjacent crystal grains, and also found that bendability has a correlation with the Lankford value, and it is necessary to increase anisotropy of the Lankford values in order to improve bendability. Furthermore, it has been found that bendability also has a correlation with the intensity ratio (random ratio) of cube orientation {100} <001> of the texture, and it is necessary to allow the texture to have a high degree of integration of cube orientation in order to improve bendability. In order to obtain the above properties, the present inventors have found that it is important to optimize the content of Si and Mg which are major elements of the 6000 series aluminum alloy, and to optimize the production steps, in particular, to appropriately control the cooling rate after homogenization of an ingot.

The present invention has been achieved based on the above findings. An object of the present invention is to provide an aluminumalloy sheet having excellent formability which allows flat hemming, showing no orange peel surfaces and ridging marks after forming, having excellent paint bake hardenability capable of solving the problems relating to shape fixability and dent resistance, and with excellent corrosion resistance, in particular, filiform corrosion resistance, and a method for producing the same.

An aluminum alloy sheet according to the present invention for achieving the above object is a 6000 series aluminum alloy sheet, with excellent bendability after a solution treatment and quenching, and has a minimum inner bending radius of 0.5 mm or less during 180° bending with 10% pre-stretch, even if the yield strength is further increased through natural aging. Possible embodiments of the aluminum alloy sheet are as follows.
(1) An aluminum alloy sheet comprising 0.5-1.5% of Si and 0.2-1.0% of Mg, with the balance consisting of Al and impurities, or comprising 0.8-1.2% of Si, 0.4-0.7% of Mg, and 0.1-0.3% of Zn, with the balance consisting of Al and impurities, in which the maximum diameter of Mg-Si compounds is 10 µm or less and the number of Mg-Si compounds having a diameter of 2-10 µm is 1000 per mm² or less.
(2) An aluminum alloy sheet comprising 0.4-1.5% of Si, 0.2-1.2% of Mg, and 0.05-0.3% of Mn, with the balance consisting of Al and impurities, in which the percentage of crystal grain boundaries in which misorientation of adjacent crystal grains is 15° or less is 20% or more.
(3) The aluminum alloy sheet according to the invention as defined in claim 1 comprises 0.5-2.0% of Si and 0.2-1.5% of Mg, with 0.7Si% + Mg% ≦ 2.2%, and Si% - 0.58Mg% ≧ 0.1% being satisfied and the balance consisting of Al and impurities, in which an anisotropy of Lankford values is more than 0.4. The Lankford value r is the ratio of the logarithmic strain in the direction of the width of the sheet to the logarithmic strain in the direction of the thickness of the sheet when applying a specific amount of tensile deformation, such as 15%, to a tensile specimen, specifically, r = (logarithmic strain in the sheet width direction)/(logarithmic strain in the sheet thickness direction). The anisotropy of Lankford values is (r0 + r90 - 2 x r45)/2 (r0: r value of a tensile specimen collected in a direction at 0° to the rolling direction, r90: r value of a tensile specimen collected in a direction at 90° to the rolling direction, and r45: r value of a tensile specimen collected in a direction at 45° to the rolling direction).
(4) An aluminum alloy sheet comprising 0.5-2.0% of Si and 0.2-1.5% of Mg, with 0.7Si% + Mg% ≦ 2.2% being satisfied and the balance cons isting of Al and impurities, in which an intensity ratio of cube orientation of crystallographic texture is 20 or more.

Specific embodiments of a method for producing the above aluminum alloy sheets are as follows.
(1) A method for producing an aluminum alloy sheet comprising homogenizing an ingot of an aluminum alloy having the above composition at a temperature of 450°C or more, cooling the ingot to a temperature of 350-500°C at a cooling rate of 100°C/h or more, starting hot rolling of the ingot at the temperature, cold rolling the hot-rolled product, and subjecting the cold-rolled product to a solution heat treatment at a temperature of 500°C or more, and quenching.
(2) A method for producing an aluminum alloy sheet comprising homogenizing an ingot of an aluminum alloy having the above composition at a temperature of 450°C or more, cooling the ingot to a temperature of less than 300°C at a cooling rate of 100°C/hormore, heating the ingot to a temperature of 350-500°C and starting hot rolling of the ingot, cold rolling the hot-rolled product, and subjecting the cold-rolled product to a solution heat treatment at a temperature of 500°C or more, and quenching.
(3) A method for producing an aluminum alloy sheet comprising homogenizing an ingot of an aluminum alloy having the above composition at a temperature of 450°C or more, cooling the ingot to a temperature of less than 300°C at a cooling rate of 100°C/h ormore, cooling the ingot to room temperature, heating the ingot to a temperature of 350-500°C and starting hot rolling of the ingot, cold rolling the hot-rolled product, and subjecting the cold-rolled product to a solution heat treatment at a temperature of 500°C or more, and quenching.
The method according to the invention are defined in claims 2-4 and are given hereafter:
(4) A method for producing an aluminum alloy sheet comprising homogenizing an ingot of an aluminum alloy having the above composition at a temperature of 450°C or more, cooling the ingot to a temperature of less than 350°C at a cooling rate of 100°C/h or more, hot rolling the ingot at the temperature, cold rolling the hot-rolled product, and subjecting the cold-rolled product to a solution heat treatment at a temperature of 450°C or more, and quenching.
(5) A method for producing an aluminum alloy sheet comprising homogenizing an ingot of an aluminum alloy having the above composition at a temperature of 450°C or more, cooling the ingot to a temperature of less than 350°C at a cooling rate of 100°C/hormore, heating the ingot to a temperature of 300-500°C and starting hot rolling of the ingot, cold rolling the hot-rolled product, and subjecting the cold-rolled product to a solution heat treatment at a temperature of 450°C or more, and quenching.
(6) A method for producing an aluminum alloy sheet comprising homogenizing an ingot of an aluminum alloy having the above composition at a temperature of 450°C or more, cooling the ingot to a temperature of less than 350°C at a cooling rate of 100°C/h or more, cooling the ingot to room temperature, heating the ingot to a temperature of 300-500°C and starting hot rolling of the ingot, cold rolling the hot-rolled product, and subjecting the cold-rolled product to a solution heat treatment at a temperature of 450°C or more, and quenching.

### PREFERED EMBODYMENTS

Effects and reasons for limitations of the alloy components in the A1-Mg-Si alloy sheet of the present invention are described below.

Si is necessary to obtain strength and high paint bake hardenability (BH), and increases strength by forming Mg-Si compounds. The Si content is 0.5-2.0%. If the Si content is less than 0.5%, sufficient strength may not be obtained by heating during baking and formability may be decreased. If the Si content exceeds 2.0%, formability and shape fixability may be insufficient due to high yield strength during press working. Moreover, corrosion resistance may be decreased after painting. The Si content may preferably be 0.4-1.5%, still more preferably 0.5-1.5%, yet more preferably 0.6-1.3%, and particularly preferably 0.8-1.2%.

Mg increases strength in the same manner as Si. The Mg content is 0.2-1.5%. If the Mg content is less than 0.2%, sufficient strength may not be obtained by heating during baking. If the Mg content exceeds 1.5%, yield strength may remain high after a solution heat treatment or additional heat treatment, whereby formability and spring-back properties may be insufficient. The Mg content may preferably be 0.2-1.2%, still more preferably 0.2-1.0%, yet more preferably 0.3-0.8%, and particularly preferably 0.4-0.7%.

Si and Mg are added to satisfy the relations 0.7Si% + Mg% ≦ 2.2%, and Si% - 0.58Mg% ≧ 0.1% so that anisotropy of the Lankford values is more than 0.4 and bendability is improved. In order to increase the intensity ratio of cube orientation of the texture to obtain good bendability, Si and Mg may preferably be added to satisfy the relation 0.7Si% + Mg% ≦ 2.2%.

Zn improves zinc phosphate treatment properties during the surface treatment. The Zn content according to the invention is optionally 0.5% or less. If the Zn content exceeds 0.5%, corrosion resistance may be decreased. The Zn content may be 0.1-0.3%.

Cu improves strength and formability. The Cu content according to the invention is optionally 1.0% or less. If the Cu content exceeds 1.0%, corrosion resistance may be decreased. The Cu content may be 0.3-0.8%. If corrosion resistance is an important, the Cu content is preferably limited to 0.1% or less.

Mn, Cr, V, and Zr improve strength and refine crystal grains to prevent occurrence of orange peel surfaces during forming. The content of Mn, Cr, V, and Zr, according to the invention is optionally 1.0% or less, 0.3% or less, 0.2% or less, and 0.2% or less, respectively. If the content of Mn, Cr, V, and Zr exceeds the above upper limits, coarse intermetallic compounds may be formed, whereby formability may be decreased. The content of Mn and Zr may be 0.3% or less and 0.15% or less, respectively. The content of Mn, Cr, V, and Zr may be 0.05-0.3%, 0.05-0.15%, 0.05-0.15%, and 0.05-0.15%, respectively.

In order to improve bendability by allowing percentage of crystal grain boundaries in which misorientation of adjacent crystal grains is 15° or less to be 20% or more, Mn is added in an amount of 0.05-0.3% as an essential component.

Ti and B refine a cast structure to improve formability. The content of Ti and B according to the invention is optionally 0.1% or less and 50 ppm or less, respectively. If the content of Ti and B exceeds the above upper limits, the number of coarse intermetallic compounds may be increased, whereby formability may be decreased. It is preferable to limit the Fe content to 0.5% or less, and preferably 0.3% or less as another impurity.

The production steps of the aluminum alloy sheet of the present invention are described below.

Homogenization condition: Homogenization must be performed at a temperature of 450°C or more. If the homogenization temperature is less than 450°C, removal of ingot segregation and homogenization may be insufficient. This results in insufficient dissolution of Mg₂Si components which contribute to strength, whereby formability may be decreased. Homogenization is preferably performed at a temperature of 480°C or more.

Cooling after homogenization: Good properties are obtained by cooling the homogenized product at a cooling rate of preferably 100°C/h or more, and still more preferably 300°C/h or more. Since large-scale equipment is necessary for increasing the cooling rate, it is preferable to manage the cooling rate in the range of 300-1000°C/h in practice. If the cooling rate is low, Mg-Si compounds are precipitated and coarsened. In a conventional cooling method, the cooling rate is about 30°C/h in the case of cooling a large slab. However, Mg-Si compounds are precipitated and coarsened during cooling at such a low cooling rate, whereby the material may not be provided with improved bendability after the solution heat treatment and quenching.

If the cooling rate is controlled in this manner, (1) appropriate distributions of Mg-Si compounds are obtained, (2) the percentage of crystal grain boundaries in which misorientation of adjacent crystal grains is 15° or less becomes 20% or more, (3) anisotropy of Lankford values is increased, and (4) the degree of integration of cube orientation is increased, whereby bendability is improved.

The cooling after homogenization must allow the temperature to be decreased to less than 350°C, and preferably less than 300°C at a cooling rate of 100°C/h or more, preferably 150°C/h or more, and still more preferably at 300°C/h or more. The properties are affected if a region at 350°C or more is partially present. Therefore, an ingot is cooled until the entire ingot is at 300°C or less, and preferably 250°C or less at the above cooling rate. There are no specific limitations to the method of cooling the homogenized ingot insofar as the necessary cooling rate is obtained. For example, water-cooling, fan cooling, mist cooling, or heat sink contact may be employed as the cooling method.

The cooling start temperature is not necessarily the homogenization temperature. The same effect can be obtained by allowing the ingot to be cooled to a temperature at which precipitation does not significantly occur, and starting cooling at a cooling rate of 100°C/h or more. For example, in the case where homogenization is performed at a temperature of 500°C or more, the ingot may be slowly cooled to 500°C.

Hot rolling: The ingot is cooled to a specific temperature of 350-500°C or 300-450°C from the homogenization temperature, and hot rolling is started at the specific temperature. The ingot may be cooled to a specific temperature of 350°C or less from the homogenization temperature, and hot rolling may be started at the specific temperature.

The ingot may be cooled to a temperature of 350°C or less and heated to a temperature of 300-500°C, and hot rolling may be started at this temperature. The ingot may be cooled to a temperature of 350°C or less, cooled to room temperature, heated to a temperature of 300-500°C, and hot-rolled at this temperature.

If the hot rolling start temperature is less than 300°C, deformation resistance is increased, whereby rolling efficiency is decreased. If the hot rolling start temperature exceeds 500°C, crystal grains coarsen during rolling, whereby ridging marks readily occur in the resulting material. Therefore, it is preferable to limit the hot rolling start temperature to 300-500°C. The hot rolling start temperature is still more preferably 380-450°C taking into consideration deformation resistance and uniform microstructure.

The hot rolling finish temperature is preferably 300°C or less. If the hot rolling finish temperature exceeds 300°C, precipitation of Mg-Si compounds easily occurs, whereby formability may be decreased. Moreover, recrystallized grains coarsen, thereby resulting in occurrence of ridging marks. Hot rolling is preferably finished at 200°C or more taking into consideration deformation resistance during hot rolling and residual oil stains due to a coolant.

Cold rolling : The hot rolled sheet is cold rolled to the final gage.

Solution heat treatment: The solution heat treatment temperature is preferably 450°C ormore, and still more preferably 500°C or more. If the solution heat treatment temperature is less than 500°C, dissolution of Mg-Si precipitates may be insufficient, whereby sufficient strength and formability cannot be obtained, or heat treatment for a considerably long time is needed to obtain necessary strength and formability. This is disadvantageous from the industrial point of view. There are no specific limitations to the solution heat treatment time insofar as necessary strength is obtained. The solution heat treatment time is usually 120 seconds or less from the industrial point of view.

Cooling rate during quenching: It is necessary to cool the sheet from the solution treatment temperature to 120°C or less at a cooling rate of 5°C/s or more. It is preferable to cool the sheet at a cooling rate of 10°C/s or more. If the quenching cooling rate is too low, precipitation of eluted elements occurs, whereby strength, BH, formability, and corrosion resistance may be decreased.

Additional heat treatment: this heat treatment is performed at 40-120°C for 50 hours or less within 60 minutes after quenching. BH is improved by this treatment. If the temperature is less than 40°C, improvement of BH is insufficient. If the temperature exceeds 120°C or the time exceeds 50 hours, the initial yield strength is excessively increased, whereby formability or paint bake hardenability is decreased.

Reversion treatment may be performed at a temperature of 170-230°C for 60 seconds or less within seven days after final additional heat treatment. Paint bake hardenability is further improved by the reversion treatment.

A sheet material with excellent bendability after the solution heat treatment and quenching can be obtained by applying the above production steps to an aluminum alloy having the above composition. The aluminum alloy sheet is suitably used as a lightweight automotive member having a complicated shape which is subjected to hemming, such as a hood, trunk lid, and door. Moreover, in the case where the aluminum alloy sheet is applied to a fender, roof, and the like, which are not subjected to hemming, the aluminum alloy sheet can be subjected to severe working in which the bending radius is small due to its excellent bendability after pressing the sheet into a complicated shape. Therefore, the aluminum alloy sheet widens the range of application of aluminum materials to automotive materials, thereby contributing to a decrease in the weight of vehicles.

In order to securely improve formability, in particular, bendability, it is preferable to adjust the amount of alloy components, such as Si and Mg, and production conditions so that anisotropy of the Lankford values is 0.6 or more and the intensity ratio of cube orientation of the texture is 50 or more.

The present invention is described below by comparing examples of the present invention with comparative examples. The effects of the present invention will be demonstrated based on this comparison. The examples illustrate only one preferred embodiment of the present invention, which should not be construed as limiting the present invention.

### Example 1

Aluminum alloys having compositions shown in Table 1 were cast by using a DC casting method. The resulting ingots were homogenized at 540°C for six hours and cooled to room temperature at a cooling rate of 300°C/h. The cooled ingots were heated to a temperature of 400°C, and hot rolling was started at this temperature. The ingots were rolled to a thickness of 4.0 mm, and cold-rolled to a thickness of 1.0 mm.

The cold-rolled sheets were subjected to a solution heat treatment at 540°C for five seconds, quenched to a temperature of 120°C at a cooling rate of 30°C/s, and additional heat treated at 100°C for three hours after five minutes.

The final heat treated sheets were used as test materials. Tensile properties, formability, corrosion resistance, and bake hardenability were evaluated when 10 days were passed after the final heat treatment, and the maximum diameter of Mg-Si compounds and the number of compounds having a diameter of 2-10 µm were measured according to the following methods. The tensile properties and a minimum bending radius for formability were also evaluated when four months were passed after the final heat treatment. The results are shown in Tables 2 and 3.

Tensile property: Tensile strength (σ_{B}), yield strength (σ_{0.2}), and elongation (δ) were measured by performing a tensile test.

Formability: An Erichsen test (EV) was performed. A test material having a forming height of less than 10 mm was rejected. A 180° bending test for measuring the minimum bending radius after applying 10% tensile pre-strain was performed in order to evaluate hem workability. A test material having a minimum inner bending radius of 0.5 mm or less was accepted.

Corrosion resistance: The test material was subjected to a zinc phosphate treatment and electrodeposition coating using commercially available chemical treatment solutions. After painting crosscuts reaching the aluminum base material, a salt spray test was performed for 24 hours according to JIS Z2371. After allowing the test material to stand in a wet atmosphere at 50°C and 95% for one month, the maximum length of filiform corrosion occurring from the crosscuts was measured. A test material having a maximum length of filiform corrosion of 4 mm or less was accepted.

Bake hardenability (BH): Yield strength (σ0.2) was measured after applying 2% tensile deformation and performing heat treatment at 170°C for 20 minutes. A test material having a yield strength of 200 MPa or more was accepted.

Measurement of Mg-Si compound: The maximum diameter of Mg-Si compounds was measured by observation using an optical microscope. The distribution of compounds having a diameter of 2-10 µm was examined using an image analyzer in the range of 1 square millimeter (1 mm²) in total provided that one pixel = 0.25 µm. The Mg-Si compounds were distinguished from Al-Fe compounds by light and shade of the compounds. The detection conditions were selected at a level at which only the Mg-Si compounds were detected by confirming the compound particles in advance by point analysis.

**TABLE 1**

| Alloy | Composition (mass%) | | | | | | | | | | |
|---|---|---|---|---|---|---|---|---|---|---|---|
| | Si | Mg | Cu | Mn | Cr | V | Zr | Fe | Zn | Ti | B |
| 1 | 1.0 | 0.5 | - | - | - | - | - | 0.17 | 0.02 | 0.02 | 5 |
| 2 | 0.8 | 0.6 | 0.02 | 0.08 | - | - | - | 0.17 | 0.02 | 0.02 | 5 |
| 3 | 1.1 | 0.5 | 0.01 | 0.08 | - | - | - | 0.17 | 0.02 | 0.02 | 5 |
| 4 | 1.0 | 0.6 | 0.7 | 0.1 | - | - | - | 0.17 | 0.02 | 0.02 | 5 |
| 5 | 1.2 | 0.4 | 0.01 | - | 0.1 | - | - | 0.17 | 0.02 | 0.02 | 5 |
| 6 | 1.1 | 0.5 | 0.01 | 0.15 | - | 0.12 | - | 0.13 | 0.04 | 0.02 | 5 |
| 7 | 1.1 | 0.5 | 0.4 | 0.07 | - | - | 0.08 | 0.15 | 0.03 | 0.02 | 5 |

| | | | | | | | | | | | |
|---|---|---|---|---|---|---|---|---|---|---|---|
| Note: Unit for B is ppm. | | | | | | | | | | | |

**TABLE 2**

| Test material | Alloy | Tensile properties | | | Formability | | Corrosion resistance | BH |
|---|---|---|---|---|---|---|---|---|
| | | σ_{B} (MPa) | σ_{0.2} (MPa) | δ (%) | EV (mm) | Minimum inner bending radius (mm) | Maximum length of filiform corrosion (mm) | σ_{0.2} after BH (MPa) |
| 1 | 1 | 242 | 125 | 31 | 10.8 | 0.1 | 0 | 211 |
| 2 | 2 | 245 | 131 | 30 | 10.4 | 0.2 | 1.5 | 220 |
| 3 | 3 | 243 | 127 | 32 | 10.6 | 0.1 | 0.5 | 214 |
| 4 | 4 | 274 | 134 | 31 | 10.5 | 0.2 | 3.5 | 221 |
| 5 | 5 | 257 | 135 | 32 | 10.6 | 0.2 | 1.0 | 217 |
| 6 | 6 | 259 | 132 | 30 | 10.2 | 0.3 | 1.0 | 208 |
| 7 | 7 | 268 | 136 | 30 | 10.3 | 0.2 | 2.5 | 223 |

**TABLE 3**

| Test material | Alloy | Maximum diameter of Mg-Si compound (µm) | Number of compounds with diameter of 2-10 µm (/mm²) | Properties after natural aging for 4 months | |
|---|---|---|---|---|---|
| | | | | σ_{0.2} (MPa) | Minimum inner bending radius (mm) |
| 1 | 1 | 6 | 550 | 143 | 0.2 |
| 2 | 2 | 8 | 800 | 147 | 0.3 |
| 3 | 3 | 6 | 650 | 142 | 0.2 |
| 4 | 4 | 9 | 720 | 150 | 0.3 |
| 5 | 5 | 5 | 580 | 152 | 0.4 |
| 6 | 6 | 5 | 520 | 151 | 0.4 |
| 7 | 7 | 6 | 600 | 155 | 0.3 |

As shown in Tables 2 and 3, testmaterials Nos. 1 to 7 according to The present invention showed excellent BH of more than 200 MPa in the BH evaluation. The test materials Nos. 1 to 7 had excellent formability in which the forming height (EV) was more than 10 mm and the minimum inner bending radius was 0.5 mm or less. The test materials Nos. 1 to 7 exhibited excellent corrosion resistance in which the maximum length of filiform corrosion was 4 mm or less.

### Comparative Example 1

Aluminum alloys having compositions shown in Table 4 were cast by using a DC casting method. The resulting ingots were treated by the same steps as in Example 1 to obtain cold-rolled sheets with a thickness of 1 mm. The cold-rolled sheets were subjected to a solution heat treatment and quenching under the same conditions as in Example 1, and heat treatment at 100°C for three hours after five minutes.

The final heat treated sheets were used as test materials. Tensile properties, formability, corrosion resistance, and bake hardenability of the test materials were evaluated when 10 days were passed after final heat treatment, and the maximum diameter of Mg-Si compounds and the number of compounds having a diameter of 2-10 µm were measured according to the same methods as in Example 1. The tensile properties and the minimum inner bending radius for formability evaluation were also evaluated when four months were passed after the final heat treatment. The results are shown in Tables 5 and 6.

**TABLE 4**

| Alloy | Composition (mass%) | | | | | | | | | | |
|---|---|---|---|---|---|---|---|---|---|---|---|
| | Si | Mg | Cu | Mn | Cr | V | Zr | Fe | Zn | Ti | B |
| 8 | 0.3 | 0.6 | 0.01 | 0.05 | 0.01 | - | - | 0.2 | 0.03 | 0.02 | 5 |
| 9 | 1.9 | 0.6 | 0.01 | 0.05 | 0.01 | - | - | 0.2 | 0.03 | 0.02 | 5 |
| 10 | 1.1 | 0.1 | 0.01 | 0.05 | 0.01 | - | - | 0.2 | 0.03 | 0.02 | 5 |
| 11 | 1.1 | 1.4 | 0.01 | 0.05 | 0.01 | - | - | 0.2 | 0.03 | 0.02 | 5 |
| 12 | 1.1 | 0.5 | 1.5 | 0.05 | 0.01 | - | - | 0.2 | 0.03 | 0.02 | 5 |
| 13 | 1.1 | 0.5 | 0.02 | 0.5 | 0.01 | - | - | 0.2 | 0.03 | 0.02 | 5 |
| 14 | 1.1 | 0.5 | 0.02 | 0.02 | 0.4 | - | - | 0.2 | 0.03 | 0.02 | 5 |
| 15 | 1.1 | 0.5 | 0.02 | 0.02 | 0.01 | 0.4 | - | 0.2 | 0.03 | 0.02 | 5 |
| 16 | 1.1 | 0.5 | 0.02 | 0.02 | 0.01 | - | 0.3 | 0.2 | 0.03 | 0.02 | 5 |

| | | | | | | | | | | | |
|---|---|---|---|---|---|---|---|---|---|---|---|
| Note: Unit for B is ppm. | | | | | | | | | | | |

**TABLE 5**

| Test material | Alloy | Tensile properties | | | Formability | | Corrosion resistance | BH |
|---|---|---|---|---|---|---|---|---|
| | | σ_{B} (MPa) | σ_{0.2} (MPa) | δ (%) | EV (mm) | Minimum inner bending radius (mm) | Maximum length of filiform corrosion (mm) | σ_{0.2} after BH (MPa) |
| 8 | 8 | 163 | 70 | 30 | 10.7 | 0 | 0.5 | 125 |
| 9 | 9 | 265 | 139 | 31 | 10.5 | 0.5 | 1.0 | 224 |
| 10 | 10 | 157 | 65 | 32 | 10.8 | 0 | 1.5 | 118 |
| 11 | 11 | 280 | 141 | 29 | 10.2 | 0.6 | 1.0 | 229 |
| 12 | 12 | 294 | 132 | 30 | 10.6 | 0.4 | 5.0 | 228 |
| 13 | 13 | 247 | 130 | 28 | 9.7 | 0.6 | 1.0 | 217 |
| 14 | 14 | 246 | 128 | 29 | 9.6 | 0.4 | 1.0 | 214 |
| 15 | 15 | 247 | 129 | 28 | 9.8 | 0.5 | 1.0 | 212 |
| 16 | 16 | 245 | 132 | 27 | 9.5 | 0.7 | 1.5 | 213 |

**TABLE 6**

| Test material | Alloy | Maximum diameter of Mg-Si compound (µm) | Number of compounds with diameter of 2-10 µm (/mm²) | Properties after natural aging for 4 months | |
|---|---|---|---|---|---|
| | | | | σ_{0.2} (MPa) | Minimum inner bending radius (mm) |
| 8 | 8 | 4 | 300 | 85 | 0 |
| 9 | 9 | 15 | 1350 | 158 | 0.7 |
| 10 | 10 | 3 | 260 | 79 | 0 |
| 11 | 11 | 18 | 2430 | 159 | 0.7 |
| 12 | 12 | 9 | 880 | 154 | 0.5 |
| 13 | 13 | 12 | 1250 | 146 | 0.7 |
| 14 | 14 | 8 | 940 | 143 | 0.5 |
| 15 | 15 | 12 | 1120 | 146 | 0.6 |
| 16 | 16 | 14 | 1290 | 148 | 0.7 |

As shown in Tables 5 and 6, test material No. 8 and test material No. 10 showed insufficient BH due to low Si content and low Mg content, respectively. Test material No. 9 and test material No. 11 had insufficient bendability due to high Si content and high Mg content, respectively. Test material No. 12 had inferior filiform corrosion resistance due to high Cu content. Test materials Nos. 13 to 16 had a small forming height (EV) due to high Mn content, high Cr content, high V content, and high Zr content, respectively. Moreover, these test materials showed insufficient bendability.

### Example 2 and Comparative Example 2

Ingots of the alloys Nos.1 and 3 of Example 1 were homogenized at 540°C for eight hours. The ingots were cooled to the hot rolling temperature after homogenization, and hot rolling was started at the temperatures shown in Table 7. The thickness of hot-rolled products was 4.5 mm. The hot-rolled products were cold-rolled to a thickness of 1 mm, subjected to a solution heat treatment under the conditions shown in Table 7, quenched to 120°C at a cooling rate of 15°C/s, and additional heat treatment at 90°C for five hours after 10 minutes. In Example 2 and Comparative Example 2, the ingots were cooled to the hot rolling temperature after homogenization, and hot rolling was performed at this temperature.

The final heat treated sheets were used as test materials. Tensile properties, formability, corrosion resistance, and bake hardenability of the test materials were evaluated when 10 days were passed after final heat treatment, and the maximum diameter of Mg-Si compounds and the number of compounds having a diameter of 2-10 µm were measured according to the same methods as in Example 1. The tensile properties and the minimum bending radius for formability evaluation were also evaluated when four months were passed after the final heat treatment. Electrodeposition coating was performed after applying 10% tensile deformation in the direction at 90° to the rolling direction. The presence or absence of ridging marks was evaluated with the naked eye. The results are shown in Tables 8 and 9.

**TABLE 7**

| Test material | Alloy | Cooling rate after homogenization (°C/h) | Hot rolling start temperature (°C) | Solution heat treatment condition (°C)-(sec) |
|---|---|---|---|---|
| 17 | 1 | 150 | 370 | 550-3 |
| 18 | 1 | 800 | 450 | 520-5 |
| 19 | 3 | 200 | 400 | 530-7 |
| 20 | 3 | 600 | 440 | 550-5 |
| 21 | 3 | 2000 | 470 | 560-3 |
| 22 | 1 | 30 | 420 | 550-3 |
| 23 | 1 | 70 | 400 | 550-3 |
| 24 | 1 | 200 | 550 | 520-7 |
| 25 | 3 | 150 | 410 | 450-3 |
| 26 | 3 | 20 | 450 | 520-5 |

**TABLE 8**

| Test material | Alloy | Tensile properties | | | Formability | | | Corrosion resistance | BH |
|---|---|---|---|---|---|---|---|---|---|
| | | σ_{B} (MPa) | σ_{0.2} (MPa) | δ (%) | EV (mm) | Minimum inner bending radius (mm) | Occurrence of ridging mark | Maximum length of filiform corrosion (mm) | σ_{0.2} after BH (MPa) |
| 17 | 1 | 243 | 123 | 30 | 10.7 | 0.1 | None | 1.0 | 210 |
| 18 | 1 | 248 | 126 | 31 | 10.6 | 0 | None | 1.5 | 218 |
| 19 | 3 | 244 | 125 | 31 | 10.5 | 0 | None | 0.5 | 215 |
| 20 | 3 | 249 | 127 | 30 | 10.4 | 0 | None | 0.5 | 216 |
| 21 | 3 | 252 | 129 | 311 | 10.5 | 0.1 | None | 0.5 | 215 |
| 22 | 1 | 195 | 80 | 30 | 10.8 | 0 | None | 1.0 | 180 |
| 23 | 1 | 207 | 92 | 30 | 10.7 | 0 | None | 1.0 | 188 |
| 24 | 1 | 245 | 127 | 31 | 10.5 | 0.2 | Observed | 0.5 | 220 |
| 25 | 3 | 201 | 92 | 32 | 10.5 | 0 | None | 2.0 | 162 |
| 26 | 3 | 210 | 105 | 31 | 10.7 | 0 | None | 1.5 | 185 |

**TABLE 9**

| Test material | Alloy | Maximum diameter of Mg-Si compound (µm) | Number of compounds with diameter of 2-10 µm (/mm²) | Properties after natural aging for 4 months | |
|---|---|---|---|---|---|
| | | | | σ_{0.2} (MPa) | Minimum inner bending radius (mm) |
| 17 | 1 | 8 | 470 | 141 | 0.2 |
| 18 | 1 | 7 | 630 | 143 | 0.1 |
| 19 | 3 | 6 | 570 | 142 | 0 |
| 20 | 3 | 6 | 660 | 142 | 0.1 |
| 21 | 3 | 6 | 750 | 142 | 0.1 |
| 22 | 1 | 22 | 1800 | 97 | 0 |
| 23 | 1 | 17 | 1520 | 108 | 0 |
| 24 | 1 | 8 | 1360 | 146 | 0.3 |
| 25 | 3 | 15 | 2520 | 106 | 0 |
| 26 | 3 | 26 | 2400 | 127 | 0 |

As shown in Tables 8 and 9, test materials Nos. 17 to 21 according to the present invention showed excellent tensile strength, BH, formability, and corrosion resistance, and maintained excellent bendability after natural aging for four months. Test materials Nos. 22, 23, and 26 had low tensile strength since the cooling rate after homogenization was low. Moreover, these test materials showed insufficient BH. Ridging marks occurred in test material No. 24 due to grain growth during hot rolling since the hot rolling temperature was high. Test material No.25 had a low tensile strength and inferior BH due to a low solution heat treatment temperature.

### Example 3 and Comparative Example 3

Aluminum alloys having compositions shown in Table 10 were cast by using a DC casting method. The resulting ingots were homogenized at 540°C for six hours and cooled to room temperature at a cooling rate of 300°C/h. The ingots were then heated to a temperature of 400°C. Hot rolling was started at this temperature. The ingots were hot-rolled to a thickness of 4.0 mm, and cold-rolled to a thickness of 1.0 mm.

The cold-rolled sheets were subjected to a solution heat treatment at 540°C for five seconds, quenched to a temperature of 120°C at a cooling rate of 30°C/s, and additional heat treated at 90°C for three hours after five minutes.

The final heat treated sheets were used as test materials. Tensile properties, formability, corrosion resistance, and bake hardenability of the test materials were evaluated when 10 days were passed after final heat treatment, and the maximum diameter of Mg-Si compounds and the number of compounds having a diameter of 2-10 µm were measured according to the same methods as in Example 1. The tensile properties and the minimum bending radius for formability evaluation were also evaluated when four months were passed after the final heat treatment. The results are shown in Tables 11 and 12.

**TABLE 10**

| Alloy | Composition (mass%) | | | | | | | | | | |
|---|---|---|---|---|---|---|---|---|---|---|---|
| | Si | Mg | Zn | Cu | Mn | Cr | V | Zr | Fe | Ti | B |
| 17 | 1.0 | 0.5 | 0.18 | - | - | - | - | - | 0.17 | 0.02 | 5 |
| 18 | 0.9 | 0.6 | 0.28 | - | - | - | - | - | 0.17 | 0.02 | 5 |
| 19 | 1.1 | 0.45 | 0.2 | 0.01 | 0.01 | - | - | - | 0.14 | 0.02 | 5 |
| 20 | 1.0 | 0.5 | 0.15 | 0.03 | 0.04 | 0.1 | - | - | 0.15 | 0.02 | 5 |
| 21 | 1.1 | 0.6 | 0.2 | 0.02 | 0.03 | - | 0.1 | - | 0.17 | 0.02 | 5 |
| 22 | 1.2 | 0.7 | 0.25 | 0.01 | 0.05 | 0.2 | - | 0.08 | 0.14 | 0.02 | 5 |
| 23 | 0.3 | 0.6 | 0.2 | 0.02 | 0.08 | - | - | - | 0.16 | 0.02 | 5 |
| 24 | 1.6 | 0.6 | 0.2 | 0.02 | 0.07 | - | - | - | 0.16 | 0.02 | 5 |
| 25 | 1.1 | 0.1 | 0.2 | 0.01 | 0.15 | - | - | - | 0.16 | 0.02 | 5 |
| 26 | 1.1 | 1.4 | 0.2 | 0.01 | 0.08 | - | - | - | 0.16 | 0.02 | 5 |
| 27 | 1.1 | 0.5 | 0.04 | 0.02 | - | - | - | - | 0.16 | 0.02 | 5 |
| 28 | 1.1 | 0.5 | 0.6 | 0.01 | 0.1 | 0.1 | - | - | 0.16 | 0.02 | 5 |
| 29 | 1.1 | 0.5 | 0.2 | 0.02 | 0.07 | - | - | - | 0.5 | 0.02 | 5 |

| | | | | | | | | | | | |
|---|---|---|---|---|---|---|---|---|---|---|---|
| Note: Unit for B is ppm. | | | | | | | | | | | |

**TABLE 11**

| Test material | Alloy | Tensile properties | | | Formability | | Corrosion resistance | BH |
|---|---|---|---|---|---|---|---|---|
| | | σ_{B} (MPa) | σ_{0.2} (MPa) | δ (%) | EV (mm) | Minimum inner bending radius (mm) | Maximum length of filiform corrosion (mm) | σ_{0.2} after BH (MPa) |
| 27 | 17 | 243 | 124 | 30 | 10.8 | 0 | 0.5 | 208 |
| 28 | 18 | 247 | 126 | 30 | 10.6 | 0.1 | 1.5 | 210 |
| 29 | 19 | 246 | 128 | 31 | 10.8 | 0 | 1.0 | 213 |
| 30 | 20 | 247 | 125 | 31 | 10.6 | 0 | 1.5 | 209 |
| 31 | 21 | 249 | 127 | 30 | 10.6 | 0.1 | 1.5 | 211 |
| 32 | 22 | 251 | 129 | 29 | 10.5 | 0.2 | 1.5 | 214 |
| 33 | 23 | 186 | 75 | 31 | 10.8 | 0 | 0 | 149 |
| 34 | 24 | 254 | 137 | 30 | 10.9 | 0.3 | 1.0 | 216 |
| 35 | 25 | 182 | 77 | 32 | 11 | 0 | 1 | 172 |
| 36 | 26 | 280 | 142 | 29 | 10.2 | 0.6 | 1.0 | 229 |
| 37 | 27 | 245 | 128 | 30 | 10.4 | 0 | 2.0 | 215 |
| 38 | 28 | 247 | 132 | 29 | 10.6 | 0 | 3.0 | 218 |
| 39 | 29 | 252 | 134 | 28 | 9.4 | 0.4 | 1.5 | 221 |

**TABLE 12**

| Test material | Alloy | Maximum diameter of Mg-Si compound (µm) | Number of compounds with diameter of 2-10 µm (/mm²) | Properties after natural aging for 4 months | |
|---|---|---|---|---|---|
| | | | | σ_{0.2} (MPa) | Minimum inner bending radius (mm) |
| 27 | 17 | 8 | 560 | 142 | 0.1 |
| 28 | 18 | 9 | 820 | 144 | 0.2 |
| 29 | 19 | 7 | 540 | 145 | 0.1 |
| 30 | 20 | 8 | 810 | 145 | 0.1 |
| 31 | 21 | 8 | 820 | 144 | 0.1 |
| 32 | 22 | 9 | 830 | 146 | 0.2 |
| 33 | 23 | 6 | 380 | 93 | 0 |
| 34 | 24 | 12 | 890 | 156 | 0.5 |
| 35 | 25 | 5 | 250 | 94 | 0 |
| 36 | 26 | 18 | 2430 | 158 | 0.7 |
| 37 | 27 | 8 | 710 | 144 | 0.1 |
| 38 | 28 | 7 | 860 | 150 | 0.2 |
| 39 | 29 | 8 | 1140 | 150 | 0.5 |

As shown in Tables 11 and 12, test materials Nos. 27 to 32 according to the present invention showed excellent BH of more than 200 MPa in the BH evaluation. The test materials Nos. 27 to 32 had excellent formability in which the forming height (EV) was more than 10 mm and the minimum inner bending radius was 0.2 mm or less. The test materials Nos. 27 to 32 exhibited excellent corrosion resistance in which the maximum length of filiform corrosion was 2 mm or less.

On the contrary, test material No. 33 and test material No. 35 showed insufficient BH due to low Si content and low Mg content, respectively. Test material No. 34 and test material No. 36 exhibited insufficient bendability due to high Si content and high Mg content, respectively. Test materials Nos. 37 and 38 exhibited inferior filiform corrosion resistance due to low Zn content and high Zn content, respectively. Test material No.39 had a small forming height (EV) due to high Fe content. Moreover, the test material No.39 showed insufficient bendability.

### Example 4 and Comparative Example 4

Ingots of the alloy No.17 of Example 3 were homogenized at 540°C for five hours. The ingots were cooled and hot-rolled to a thickness of 5.0 mm under conditions shown in Table 13. The hot-rolled products were cold-rolled to a thickness of 1.0 mm, subjected to a solution heat treatment under conditions shown in Table 13, quenched to 120°C at a cooling rate of 150°C/s, and additional heat treated at 80°C for two hours after five minutes. In Example 4 and Comparative Example 4, the ingots were cooled to the hot rolling temperature after homogenization, and hot rolling was started at this temperature.

The final heat treated sheets were used as test materials. Tensile properties, formability, corrosion resistance, and bake hardenability of the test materials were evaluated when 10 days were passed after final heat treatment, and the maximum diameter of Mg-Si compounds and the number of compounds having a diameter of 2-10 µm were measured according to the same methods as in Example 1. The tensile properties and theminimumbending radius for formability evaluation were also evaluated when four months were passed after the final heat treatment. Electrodeposition coating was performed after applying 10% tensile deformation in the direction at 90° to the rolling direction. The presence or absence of ridging marks was evaluated with the naked eye. The results are shown in Tables 14 and 15.

**TABLE 13**

| Test material | Alloy | Cooling rate after homogenization (°C/h) | Hot rolling start temperature (°C) | Solution heat treatment condition (°C)-(sec) |
|---|---|---|---|---|
| 40 | 17 | 300 | 400 | 550-5 |
| 41 | 17 | 200 | 470 | 530-10 |
| 42 | 17 | 600 | 440 | 540-10 |
| 43 | 17 | 40 | 450 | 550-5 |
| 44 | 17 | 300 | 540 | 520-10 |
| 45 | 17 | 250 | 420 | 450-10 |

**TABLE 14**

| Test material | Alloy | Tensile properties | | | Formability | | | Corrosion resistance | BH |
|---|---|---|---|---|---|---|---|---|---|
| | | σ_{B} (MPa) | σ_{0.2} (MPa) | δ (%) | EV (mm) | Inner minimum bending radius (mm) | Occurrence of ridging mark | Maximum length of filiform corrosion (mm) | σ_{0.2} after BH (MPa) |
| 40 | 17 | 245 | 125 | 30 | 10.7 | 0 | None | 0.5 | 207 |
| 41 | 17 | 240 | 124 | 31 | 10.8 | 0 | None | 1.0 | 208 |
| 42 | 17 | 247 | 128 | 30 | 10.7 | 0 | None | 1.0 | 207 |
| 43 | 17 | 205 | 97 | 30 | 10.8 | 0 | None | 1.0 | 175 |
| 44 | 17 | 248 | 129 | 31 | 10.5 | 0.1 | Observed | 0.5 | 209 |
| 45 | 17 | 195 | 84 | 31 | 11.0 | 0 | None | 0.5 | 162 |

**TABLE 15**

| Test material | Alloy | Maximum diameter of Mg-Si compound (µm) | Number of compounds with diameter of 2-10 µm (/mm²) | Properties after natural aging for 4 months | |
|---|---|---|---|---|---|
| | | | | σ_{0.2} (MPa) | Minimum inner bending radius (mm) |
| 40 | 17 | 7 | 620 | 141 | 0.1 |
| 41 | 17 | 8 | 750 | 140 | 0.1 |
| 42 | 17 | 7 | 580 | 144 | 0.1 |
| 43 | 17 | 15 | 1360 | 111 | 0 |
| 44 | 17 | 7 | 1550 | 146 | 0.2 |
| 45 | 17 | 18 | 2420 | 97 | 0 |

As shown in Tables 14 and 15, test materials Nos. 40 to 42 according to the present invention showed excellent tensile strength, BH, formability, and corrosion resistance, and maintained excellent bendability after natural aging for four months. Test material No. 43 had low tensile strength and insufficient BH since the cooling rate after homogenization was low. Ridging marks occurred in test material No. 44 due to texture growth during hot rolling, since the hot rolling temperature was high. Test material No. 45 had a low tensile strength and inferior BH due to a low solution treatment temperature.

### Example 5

Aluminum alloys having compositions shown in Table 16 were cast by using a DC casting method. The resulting ingots were homogenized at 540°C for six hours and cooled to room temperature at a cooling rate of 300°C/h. The ingots were heated to a temperature of 400°C, and hot rolling was started at this temperature. The ingots were hot-rolled to a thickness of 4.0 mm, and cold-rolled to a thickness of 1.0 mm.

The cold-rolled sheets were subjected to a solution heat treatment at 540°C for five seconds, quenched to a temperature of 120°C at a cooling rate of 30°C/s, and additional heat treated at 100°C for three hours after five minutes.

The final heat treated sheets were used as test materials. Tensile properties, formability, corrosion resistance, and bake hardenability of the test materials were evaluated according to the same methods as in Example 1 when 10 days were passed after final heat treatment. In addition, misorientation distributions of crystal grain boundaries were measured according to the following method. The results are shown in Table 17.

Measurement of misorientation distribution of crystal grain boundaries: The surface of the test material was ground using emery paper and mirror-ground by electrolytic grinding. The test material was set in a scanning electron microscope (SEM) . The tilt angle distributions of the crystal grain boundaries were measured by measuring the crystal grain orientation at a pitch of 10 µm using an EBSP device installed in the SEM at an observation magnification of 100 times to calculate the percentage of crystal grain boundaries at 15° or less.

**TABLE 16**

| Alloy | Composition (mass%) | | | | | | | | | | |
|---|---|---|---|---|---|---|---|---|---|---|---|
| | Si | Mg | Cu | Mn | Cr | V | Zr | Fe | Zn | Ti | B |
| 30 | 1.0 | 0.5 | - | 0.05 | - | - | - | 0.13 | 0.01 | 0.02 | 5 |
| 31 | 0.8 | 0.6 | 0.02 | 0.08 | - | - | - | 0.15 | 0.01 | 0.03 | 7 |
| 32 | 1.2 | 0.4 | 0.01 | 0.08 | - | - | - | 0.16 | 0.02 | 0.02 | 6 |
| 33 | 1.1 | 0.5 | 0.01 | 0.08 | - | - | - | 0.19 | 0.28 | 0.02 | 4 |
| 34 | 1.0 | 0.5 | 0.7 | 0.10 | - | - | - | 0.16 | 0.02 | 0.03 | 5 |
| 35 | 1.1 | 0.4 | 0.01 | 0.05 | 0.10 | - | - | 0.17 | 0.02 | 0.03 | 6 |
| 36 | 1.1 | 0.5 | 0.01 | 0.15 | - | 0.13 | - | 0.13 | 0.04 | 0.02 | 5 |
| 37 | 1.1 | 0.5 | 0.5 | 0.07 | - | - | 0.08 | 0.15 | 0.03 | 0.02 | 4 |

| | | | | | | | | | | | |
|---|---|---|---|---|---|---|---|---|---|---|---|
| Note: Unit for B is ppm. | | | | | | | | | | | |

**TABLE 17**

| Test material | Alloy | Percentage of crystal grain boundaries at 15° or less (%) | Tensile properties | | | Formability | | Corrosion resistance | BH |
|---|---|---|---|---|---|---|---|---|---|
| | | | σₐ (MPa ) | σ_{0.2} (MPa ) | δ (%) | EV (mm) | Minimum inner bending radius (mm) | Maximum length of filiform corrosion (mm) | σ_{0.2} after BH (MPa) |
| 46 | 30 | 38 | 242 | 125 | 32 | 10.5 | 0.1 | 0 | 213 |
| 47 | 31 | 35 | 247 | 134 | 31 | 10.2 | 0.2 | 1.3 | 222 |
| 48 | 32 | 42 | 242 | 125 | 32 | 10.7 | 0.1 | 0.4 | 213 |
| 49 | 33 | 41 | 242 | 126 | 30 | 10.5 | 0.1 | 0 | 216 |
| 50 | 34 | 36 | 278 | 139 | 30 | 10.4 | 0.1 | 3.2 | 225 |
| 51 | 35 | 43 | 261 | 136 | 32 | 10.5 | 0.2 | 1.2 | 218 |
| 52 | 36 | 46 | 258 | 129 | 29 | 10.4 | 0.2 | 1.1 | 210 |
| 53 | 37 | 42 | 265 | 135 | 30 | 10.5 | 0.2 | 2.7 | 222 |

As shown in Table 17, test materials Nos. 46 to 53 according to the conditions of the present invention showed excellent BH of more than 200 MPa in the BH evaluation. The test materials Nos. 46 to 53 had excellent formability in which the forming height (EV) was more than 10 mm and the minimum inner bending radius was 0.2 mm or less. The test materials Nos. 46 to 53 exhibited excellent corrosion resistance in which the maximum length of filiform corrosion was 4 mm or less.

### Comparative Example 5

Aluminum alloys having compositions shown in Table 18 were cast by using a DC casting method. The resulting ingots were treated by the same steps as in Example 5 to obtain cold-rolled sheets with a thickness of 1.0 mm. The cold-rolled sheets were subjected to a solution heat treatment and quenched under the same conditions as in Example 1. The quenched products were additional heat treated at 100°C for three hours after five minutes.

The final heat treated sheets were used as test materials. Tensile properties, formability, corrosion resistance, and bake hardenability of the test materials were evaluated when 10 days were passed after final heat treatment, and misorientation distributions of crystal grain boundaries were measured according to the same methods as in Example 5. The results are shown in Table 19.

**TABLE 18**

| Alloy | Composition (mass%) | | | | | | | | | | |
|---|---|---|---|---|---|---|---|---|---|---|---|
| | Si | Mg | Cu | Mn | Cr | V | Zr | Fe | Zn | Ti | B |
| 38 | 0.3 | 0.5 | 0.02 | 0.06 | 0.01 | - | - | 0.15 | 0.02 | 0.03 | 5 |
| 39 | 1.7 | 0.5 | 0.02 | 0.05 | 0.01 | - | - | 0.14 | 0.03 | 0.02 | 6 |
| 40 | 1.0 | 0.1 | 0.02 | 0.04 | 0.01 | - | - | 0.17 | 0.02 | 0.03 | 4 |
| 41 | 1.1 | 1.5 | 0.02 | 0.05 | 0.01 | - | - | 0.16 | 0.03 | 0.03 | 5 |
| 42 | 1.0 | 0.5 | 0.02 | 0.06 | 0.01 | - | - | 0.13 | 0.6 | 0.02 | 4 |
| 4.3 | 1.1 | 0.6 | 1.3 | 0.05 | 0.01 | - | - | 0.15 | 0.03 | 0.02 | 6 |
| 44 | 1.0 | 0.5 | 0.01 | 0.5 | 0.01 | - | - | 0.17 | 0.03 | 0.03 | 4 |
| 45 | 1.0 | 0.5 | 0.01 | 0.06 | 0.4 | - | - | 0.16 | 0.02 | 0.02 | 5 |
| 46 | 1.1 | 0.6 | 0.01 | 0.05 | 0.01 | 0.4 | - | 0.14 | 0.02 | 0.03 | 4 |
| 47 | 1.1 | 0.6 | 0.01 | 0.06 | 0.01 | - | 0.23 | 0.16 | 0.03 | 0.02 | 5 |
| 48 | 1.0 | 0.6 | 0.02 | 0.02 | 0.01 | - | - | 0.14 | 0.02 | 0.03 | 5 |

| | | | | | | | | | | | |
|---|---|---|---|---|---|---|---|---|---|---|---|
| Note: Unit for B is ppm. | | | | | | | | | | | |

**TABLE 19**

| Test material | Alloy | Percentage of crystal grain boundaries at 15° or less (%) | Tensile properties | | | Formability | | Corrosion resistance | BH |
|---|---|---|---|---|---|---|---|---|---|
| | | | σ_{B} (MPa ) | σ_{0.2} (MPa ) | δ (%) | EV (mm) | Minimum inner bending radius (mm) | Maximum length of filiform corrosion (mm) | σ_{0.2} after BH (MPa) |
| 54 | 38 | 27 | 161 | 68 | 29 | 10.8 | 0 | 0.4 | 123 |
| 55 | 39 | 42 | 268 | 142 | 31 | 10.6 | 0.6 | 1.1 | 226 |
| 56 | 40 | 31 | 160 | 68 | 32 | 10.7 | 0 | 1.6 | 119 |
| 57 | 41 | 39 | 279 | 140 | 30 | 10.2 | 0.7 | 1.1 | 228 |
| 58 | 42 | 41 | 248 | 125 | 31 | 10.6 | 0.2 | 6.8 | 220 |
| 59 | 43 | 35 | 291 | 129 | 29 | 10.5 | 0.4 | 5.5 | 226 |
| 60 | 44 | 46 | 245 | 128 | 27 | 9.5 | 0.7 | 0.9 | 215 |
| 61 | 45 | 51 | 244 | 126 | 29 | 9.6 | 0.8 | 1.1 | 213 |
| 62 | 46 | 48 | 251 | 131 | 28 | 9.8 | 0.8 | 1.0 | 214 |
| 63 | 47 | 43 | 244 | 130 | 27 | 9.5 | 0.7 | 1.3 | 214 |
| 64 | 48 | 17 | 243 | 124 | 30 | 10.3 | 0.8 | 0.4 | 210 |

As shown in Table 19, test material No. 54 and test material No. 56 exhibited insufficient BH due to low Si content and low Mg content, respectively. Test material No. 55 and test material No. 57 exhibited insufficient bendability due to high Si content and high Mg content, respectively. Test material No. 58 and test material No. 59 showed inferior filiform corrosion resistance due to high Zn content and high Cu content, respectively. Test materials Nos. 60 to 63 had a small forming height (EV) and insufficient bendability due to high Mn content, high Cr content, high V content, and high Zr content, respectively. Test material No. 64 exhibited insufficient bendability since the percentage of crystal grain boundaries in which misorientation of adjacent crystal grains was 15° or less was less than 20% due to low Mn content.

### Example 6

Ingots of the alloy No. 30 shown in Table 16 used in Example 5 were subjected to homogenization, hot rolling, cold rolling, solution heat treatment, additional heat treatment, and reversion treatment under conditions shown in Table 20 to obtain test materials Nos. 65 to 71. In this example, the ingots were cooled to the hot rolling temperature after homogenization, and hot rolling was started at this temperature. Moreover, the homogenization time was six hours, the thickness of the hot-rolled sheet was 4.0 mm, the thickness of the cold-rolled sheet was 1.0 mm, and the period of time between quenching and additional heat treatment was five minutes. The test material No. 65 was subjected to the reversion treatment at 200°C for three seconds after the additional heat treatment. The reversion treatment was performed when one day was passed after the additional heat treatment.

Tensile properties, formability, corrosion resistance, and bake hardenability of the test materials were evaluated when 10 days were passed after final heat treatment, and misorientation distributions of crystal grain boundaries were measured according to the same methods as in Example 5. The results are shown in Table 21. Electrodeposition coating was performed after applying 10% tensile deformation in the direction at 90° to the rolling direction. The presence or absence of ridging marks was evaluated with the naked eye. As a result, occurrence of ridging marks was not observed at all.

**TABLE 20**

| Test material | Alloy | Homogenization | | Hot rolling | Solution heat treatment | | | Additional heat treatment | |
|---|---|---|---|---|---|---|---|---|---|
| | | Temp. (°C) | Cooling rate after homogenization (°C/h) | Start temperature (°C) | Temp. (°C) | Time (s) | Cooling rate (°C/s) | Temp. (°C) | Time (h) |
| 65 | 30 | 540 | 300 | 400 | 550 | 5 | 30 | 100 | 3 |
| 66 | 30 | 520 | 300 | 400 | 550 | 5 | 30 | 100 | 3 |
| 67 | 30 | 540 | 200 | 400 | 550 | 5 | 30 | 100 | 3 |
| 68 | 30 | 540 | 300 | 450 | 550 | 5 | 30 | 100 | 3 |
| 69 | 30 | 540 | 300 | 400 | 520 | 30 | 30 | 100 | 3 |
| 70 | 30 | 540 | 300 | 400 | 550 | 5 | 10 | 100 | 3 |
| 71 | 30 | 540 | 300 | 400 | 550 | 10 | 30 | 60 | 5 |

**TABLE 21**

| Test material | Alloy | Percentage of crystal grain boundaries at 15° or less (%) | Tensile properties | | | Formability | | Corrosion resistance | BH |
|---|---|---|---|---|---|---|---|---|---|
| | | | σ_{B} (MPa) | σ_{0.2} (MPa) | δ (%) (mm) | EV (mm) | Minimum inner bending radius (mm) | Maximum length of filiform corrosion (mm) | σ_{0.2} after BH (MPa) |
| 65 | 30 | 41 | 237 | 122 | 31 | 10.8 | 0.1 | 0.3 | 226 |
| 66 | 30 | 47 | 238 | 117 | 30 | 10.4 | 0.3 | 0.6 | 206 |
| 67 | 30 | 24 | 241 | 124 | 31 | 10.7 | 0.3 | 0.5 | 206 |
| 68 | 30 | 27 | 245 | 126 | 31 | 10.9 | 0 | 0.2 | 215 |
| 69 | 30 | 48 | 235 | 118 | 31 | 10.6 | 0 | 0.4 | 207 |
| 70 | 30 | 37 | 239 | 122 | 31 | 10.7 | 0.2 | 0.6 | 208 |
| 71 | 30 | 35 | 245 | 126 | 31 | 10.7 | 0.1 | 0.2 | 204 |

As shown in Table 21, the test materials Nos. 65 to 71 according to The present invention showed excellent tensile strength, BH, formability, and corrosion resistance. Moreover, occurrence of ridging marks was not observed at all.

### Comparative Example 6

Ingots of the alloy No. 30 shown in Table 16 used in Example 5 were subjected to homogenization, hot rolling, cold rolling, solution heat treatment, additional heat treatment, and reversion treatment under conditions shown in Table 22 to obtain test materials Nos. 72 to 80. In this example, the ingots were cooled to the hot rolling temperature after homogenization, and hot rolling was started at this temperature. Moreover, the homogenization time was six hours, the thickness of the hot-rolled sheet was 4.0 mm, the thickness of the cold-rolled sheet was 1.0 mm, and the period of time between quenching and additional heat treatment was five minutes. The test material No. 80 was subjected to the reversion treatment at 300°C for 30 seconds. The reversion treatment was performed when one day was passed after the additional heat treatment.

Tensile properties, formability, corrosion resistance, and bake hardenability of the test materials were evaluated when 10 days were passed after final heat treatment, and misorientation distributions of crystal grain boundaries were measured according to the same methods as in Example 5. The results are shown in Table 23. Electrodeposition coating was performed after applying 10% tensile deformation in the direction at 90° to the rolling direction. The presence or absence of ridging marks was evaluated with the naked eye. As a result, occurrence of ridging marks was observed in the test material No. 74.

**TABLE 22**

| Test material | Alloy | Homogenization | | Hot rolling | Solution heat treatment | | | Additional heat treatment | |
|---|---|---|---|---|---|---|---|---|---|
| | | Temp. (°C) | Cooling rate after homogenization (°C/h) | Start temperature (°C) | Temp. (°C) | Time (s) | Cooling rate (°C/s) | Temp. (°C) | Time (h) |
| 72 | 30 | 450 | 300 | 400 | 550 | 5 | 30 | 100 | 3 |
| 73 | 30 | 540 | 100 | 400 | 560 | 10 | 30 | 100 | 3 |
| 74 | 30 | 540 | 50 | 400 | 560 | 20 | 30 | 100 | 3 |
| 75 | 30 | 540 | 300 | 500 | 550 | 5 | 30 | 100 | 3 |
| 76 | 30 | 540 | 300 | 400 | 470 | 10 | 30 | 100 | 3 |
| 77 | 30 | 540 | 300 | 400 | 550 | 5 | 1 | 100 | 3 |
| 78 | 30 | 540 | 300 | 400 | 550 | 5 | 30 | - | - |
| 79 | 30 | 540 | 300 | 400 | 550 | 5 | 30 | 140 | 72 |
| 80 | 30 | 540 | 300 | 400 | 550 | 5 | 30 | 100 | 3 |

**TABLE 23**

| Test material | Alloy | Percentage of crystal grain boundaries at 15° or less (%) | Tensile properties | | | Formability | | Corrosion resistance | BH |
|---|---|---|---|---|---|---|---|---|---|
| | | | σ_{B} (MPa ) | σ_{0.2} (MPa ) | δ (%) | EV (mm) | Minimum inner bending radius (mm) | Maximum length of filiform corrosion (mm) | σ_{0.2} after BH (MPa) |
| 72 | 30 | 18 | 215 | 102 | 30 | 9.3 | 0.8 | 1.3 | 172 |
| 73 | 30 | 15 | 225 | 110 | 31 | 10.3 | 0.7 | 0.7 | 195 |
| 74 | 30 | 11 | 221 | 107 | 31 | 10.4 | 0.8 | 0.8 | 191 |
| 75 | 30 | 16 | 243 | 127 | 32 | 10.6 | 0.7 | 0.4 | 218 |
| 76 | 30 | 43 | 209 | 96 | 27 | 9.4 | 0 | 1.2 | 164 |
| 77 | 30 | 35 | 213 | 99 | 28 | 9.4 | 0.7 | 6.2 | 183 |
| 78 | 30 | 32 | 241 | 124 | 31 | 10.8 | 0.1 | 0.3 | 175 |
| 79 | 30 | 38 | 281 | 165 | 29 | 9.6 | 0.4 | 0.4 | 228 |
| 80 | 30 | 36 | 181 | 82 | 30 | 9.8 | 0.2 | 0.2 | 153 |

As shown in Table 23, the test material No. 72 had low EV and insufficient bendability due to a low homogenization temperature. Moreover, the test material No. 72 showed inferior BH. The test materials Nos. 73 and 74 showed insufficient bendability and inferior BH due to a low cooling rate after homogenization. Ridging marks occurred in the test material No. 75 due to inferior bendability since the hot rolling start temperature was high. The test material No. 76 had low strength and low EV due to a low solution treatment temperature. Moreover, the test material No. 76 had low BH. The test material No. 77 showed insufficient EV, bendability, and corrosion resistance due to a low quenching rate after the solution heat treatment. Moreover, the test material No. 77 showed insufficient strength and BH. The test material No. 78 had low BH since additional heat treatment was not performed. The test material No. 79 had low EV since the additional heat treatment was performed at a high temperature for a long period of time. The test material No. 80 had low strength and low BH since the reversion treatment temperature was high. Moreover, the test material No. 80 had low EV.

### Example 7

Aluminum alloys having compositions shown in Table 24 were cast by using a DC casting method. The resulting ingots were homogenized at 550°C for six hours and cooled to 200°C at a cooling rate of 600°C/h. The ingots were cooled to room temperature, heated to 420°C, and hot-rolled to a thickness of 4.5 mm. The hot rolling finish temperature was 250°C.

The hot-rolled products were cold-rolled to a thickness of 1.0 mm. The cold-rolled sheets were subjected to a solution heat treatment at 540°C for 20 seconds and quenched to 120°C at a cooling rate of 30°C/s. The quenched sheets were additional heat treated at 100°C for three hours after three minutes.

Tensile performance, anisotropy of Lankford values, bake hardenability (BH), and bendability of the aluminum alloy sheets were evaluated according to the following methods when 10 days were passed after the final heat treatment. The results are shown in Table 25.

Tensile performance: Tensile specimens were collected in three directions (at 0°, 45°, and 90° to the rolling direction), and subjected to a tensile test to determine average values of tensile strength, yield strength, and elongation as the tensile performance.

Anisotropy of Lankford values: Tensile specimens were collected in three directions (at 0°, 45°, and 90° to the rolling direction), and subjected to a tensile test to determine the Lankford values r at 15% deformation, and to calculate anisotropy of the Lankford values.

Bake hardenability (BH): Yield strength was measured after applying 2% tensile deformation in the rolling direction and performing heat treatment at 170°C for 20 minutes. A test material having a yield strength of 200 MPa or more was accepted.

Bendability: A 180° bending test for measuring the minimum bending radiuswas performed after applying 15% tensile prestrain. A test material having a minimum inner bending radius of 0.1 mm or less was accepted.

**TABLE 24**

| Alloy | Composition (wt%) | | | | | | | | | | |
|---|---|---|---|---|---|---|---|---|---|---|---|
| | Si | Mg | Zn | Cu | Mn | Cr | V | Zr | Fe | Ti | B |
| 49 | 1.0 | 0.65 | - | - | - | - | - | - | 0.25 | 0.03 | 10 |
| 50 | 1.0 | 0.48 | - | 0.02 | 0.09 | - | - | - | 0.17 | 0.02 | 5 |
| 51 | 0.91 | 0.53 | 0.18 | 0.01 | 0.1 | - | - | - | 0.18 | 0.02 | 5 |
| 52 | 1.0 | 0.4 | 0.02 | 0.72 | 0.1 | - | - | - | 0.18 | 0.02 | 5 |
| 53 | 1.6 | 0.34 | - | - | - | 0.05 | - | - | 0.18 | 0.02 | 5 |
| 54 | 1.1 | 0.54 | 0.02 | - | 0.05 | - | 0.08 | - | 0.13 | 0.01 | 7 |
| 55 | 0.8 | 1.1 | 0.01 | 0.02 | 0.07 | - | - | 0.08 | 0.15 | 0.02 | 5 |

| | | | | | | | | | | | |
|---|---|---|---|---|---|---|---|---|---|---|---|
| Note: Unit for B is ppm. | | | | | | | | | | | |

**TABLE 25**

| Test material | Alloy | Tensile performance | | | Yield strength after BH (MPa) | Anisotropy of Lankford values r | Minimum inner bending radius (mm) |
|---|---|---|---|---|---|---|---|
| | | Tensile strength (MPa) | Yield strength (MPa) | Elongation (%) | | | |
| 81 | 49 | 246 | 132 | 30 | 212 | 0.66 | 0.0 |
| 82 | 50 | 237 | 122 | 31 | 206 | 0.73 | 0.0 |
| 83 | 51 | 241 | 130 | 30 | 210 | 0.70 | 0.0 |
| 84 | 52 | 266 | 127 | 31 | 220 | 0.45 | 0.1 |
| 85 | 53 | 252 | 141 | 31 | 223 | 0.62 | 0.1 |
| 86 | 54 | 239 | 132 | 30 | 219 | 0.66 | 0.0 |
| 87 | 55 | 254 | 138 | 29 | 226 | 0.57 | 0.1 |

As shown in Table 25, test materials Nos. 81 to 87 according to the present invention excelled in strength and BH, had anisotropy of the Lankford values of more than 0.4, and showed excellent minimum bending properties. Bendability after natural aging for four months was evaluated. As a result, the test materials of all the alloys had a minimum bending radius of 0.0-0.1.

### Comparative Example 7

Aluminum alloys having compositions shown in Table 26 were cast by using a DC casting method. The resulting ingots were treated by the same steps as in Example 7. Tensile performance, anisotropy of Lankford values, bake hardenability (BH), and bendabilityof the aluminum alloy sheets were evaluated according to the same methods as in Example 7 when 10 days were passed after the final heat treatment. The results are shown in Table 27.

**TABLE 26**

| Alloy | Composition (wt%) | | | | | | | | | | |
|---|---|---|---|---|---|---|---|---|---|---|---|
| | Si | Mg | Zn | Cu | Mn | Cr | V | Zr | Fe | Ti | B |
| 56 | 0.34 | 0.6 | - | 0.01 | 0.06 | 0.01 | - | - | 0.2 | 0.02 | 5 |
| 57 | 2.4 | 0.5 | - | 0.01 | 0.06 | - | - | - | 0.18 | 0.02 | 5 |
| 58 | 1.1 | 0.14 | - | 0.01 | - | 0.05 | - | - | 0.15 | 0.02 | 5 |
| 59 | 0.7 | 1.4 | 0.1 | 0.01 | - | 0.05 | - | - | 0.15 | 0.02 | 5 |
| 60 | 1.7 | 1.3 | - | 0.01 | 0.06 | - | - | - | 0.18 | 0.02 | 5 |
| 61 | 1.1 | 0.48 | - | 1.5 | - | - | - | 0.1 | 0.18 | 0.02 | 5 |
| 62 | 1.1 | 0.53 | - | 0.02 | 1.2 | - | - | - | 0.15 | 0.02 | 5 |
| 63 | 1.1 | 0.53 | - | 0.03 | - | 0.4 | - | - | 0.17 | 0.02 | 5 |
| 64 | 1.1 | 0.45 | - | 0.02 | - | 0.01 | 0.4 | - | 0.22 | 0.02 | 5 |
| 65 | 1.1 | 0.61 | - | 0.01 | - | - | - | 0.3 | 0.14 | 0.02 | 5 |

| | | | | | | | | | | | |
|---|---|---|---|---|---|---|---|---|---|---|---|
| Note: Unit for B is ppm. | | | | | | | | | | | |

**TABLE 27**

| Test material | Alloy | Tensile performance | | | Yield strength after BH (MPa) | Anisotropy of Lankford values r | Minimum inner bending radius (mm) |
|---|---|---|---|---|---|---|---|
| | | Tensile strength (MPa) | Yield strength (MPa) | Elongation (%) | | | |
| 88 | 56 | 152 | 83 | 29 | 123 | 0.62 | 0.0 |
| 89 | 57 | 263 | 148 | 31 | 231 | 0.34 | 0.6 |
| 90 | 58 | 162 | 85 | 30 | 132 | 0.62 | 0.0 |
| 91 | 59 | 249 | 138 | 29 | 194 | 0.26 | 0.6 |
| 92 | 60 | 270 | 154 | 28 | 230 | 0.31 | 0.6 |
| 93 | 61 | 283 | 147 | 30 | 243 | 0.38 | 0.7 |
| 94 | 62 | 253 | 141 | 29 | 227 | 0.26 | 0.6 |
| 95 | 63 | 242 | 133 | 28 | 218 | 0.32 | 0.5 |
| 96 | 64 | 239 | 135 | 29 | 217 | 0.22 | 0.6 |
| 97 | 65 | 242 | 141 | 28 | 220 | 0.15 | 0.7 |

As shown in Table 27, test material No. 88 and test material No. 90 exhibited low strength and insufficient BH due to low Si content and low Mg content, respectively. Test material No. 89 had high strength due to high Si content, whereby anisotropy of Lankford values was decreased and bendabilitywas insufficient. Test material No. 91 had a small anisotropy of Lankford values since the value for (Si% - 0.58Mg%) was smaller than 0.1%, whereby minimum bendability was insufficient.

Test material No. 92 had a small anisotropy of Lankford values since (0.7Si% + Mg%) exceeded 2.2%, whereby bendability was insufficient. Test materials No. 93 to 97 had a small anisotropy of Lankford values due to high Cu content, high Mn content, high Cr content, high V content, and high Zr content, respectively, whereby bendability was insufficient.

### Example 8 and Comparative Example 8

The alloy No. 50 shown in Table 24 was cast by using a DC casting method. The resulting ingots were homogenized at 540°C for 10 hours and cooled to 250°C at cooling rates shown in Table 28. The ingots were then cooled to room temperature. The ingots were heated to the temperatures shown in Table 28 and hot-rolled to a thickness of 4.2 mm. The hot rolling finish temperature was 280°C. The hot-rolled products were cold-rolled to obtain sheets with a thickness of 1.0 mm. Only test material No. 107 was cold-rolled to a thickness of 3.0 mm and subjected to process annealing at 450°C for 30 seconds.

The cold-rolled sheets were subjected to a solution heat treatment at 550°C for 10 seconds and quenched to 120°C at a cooling rate of 30°C/s. The quenched sheets were additional heat treated at 100°C for three hours after three minutes. Tensile performance, anisotropy of Lankford values, BH, and bendability of the aluminum alloy sheets obtained by these steps were evaluated according to the same methods as in Example 7.

For the evaluation of ridging marks, tensile specimens were collected in the direction at 90° to the rolling direction and subjected to 10% tensile deformation and electrodeposition coating. The presence or absence of ridging marks was then evaluated.

The results are shown in Table 29.

**TABLE 28**

| Condition | Cooling rate after homogenization (°C/h) | Hot rolling start temperature (°C) |
|---|---|---|
| a | 550 | 420 |
| b | 200 | 400 |
| c | 3000 | 430 |
| d | 480 | 480 |
| e | 480 | 360 |
| f | 380 | 550 |
| g | 3000 | 530 |
| h | 50 | 400 |
| i | 30 | 520 |
| j | 550 | 420 |

**TABLE 29**

| Test material | Condition | Tensile performance | | | Yield strength after BH (MPa) | Anisotropy of Lankford values r | Minimum inner bending radius (mm) | Occurrence of ridging mark |
|---|---|---|---|---|---|---|---|---|
| | | Tensile strength (Mpa) | Yield strength (MPa) | Elongation (%) | | | | |
| 98 | a | 230 | 121 | 30 | 210 | 0.55 | 0.0 | None |
| 99 | b | 218 | 118 | 31 | 207 | 0.62 | 0.0 | None |
| 100 | c | 234 | 132 | 30 | 226 | 0.58 | 0.1 | None |
| 101 | d | 241 | 130 | 31 | 230 | 0.51 | 0.1 | None |
| 102 | e | 225 | 123 | 32 | 219 | 0.67 | 0.0 | None |
| 103 | f | 236 | 127 | 31 | 227 | 0.45 | 0.3 | Observed |
| 104 | g | 238 | 131 | 29 | 222 | 0.33 | 0.3 | Observed |
| 105 | h | 212 | 107 | 31 | 193 | 0.25 | 0.5 | None |
| 106 | i | 231 | 125 | 30 | 214 | 0.18 | 0.6 | Observed |
| 107 | j | 224 | 118 | 29 | 204 | 0.1 | 0.4 | None |

As shown in Table 29, test materials Nos. 98 to 102 according to The present invention excelled in strength and BH, had an anisotropy of Lankford values of more than 0.4, and showed excellent minimum bending properties.

On the contrary, ridging marks occurred in test materials Nos. 103 and 104 due to a high hot rolling temperature. Test material No. 105 had a small anisotropy of Lankford values due to a low cooling rate after homogenization, whereby bendability was insufficient. Ridging marks occurred in test material No. 106 due to a high hot rolling temperature and a low cooling rate after homogenization. Moreover, the test material No. 106 had a small anisotropy of Lankford values, whereby bendability was insufficient. Test material No. 107 had a small anisotropy of Lankford values since process annealing was performed, whereby bendability was insufficient.

### Example 9

The alloy No. 50 shown in Table 24 was cast by using a DC casting method. The resulting ingots were homogenized at 550°C for eight hours and cooled to 200°C at a cooling rate of 500°C/h. The ingots were cooled to room temperature, heated to 400°C, and hot-rolled to a thickness of 4.2 mm. The hot rolling finish temperature was 260°C.

The hot-rolled products were cold-rolled to obtain sheets with a thickness of 1.0mm. The cold-rolled sheets were subjected to a solution heat treatment at 550°C for four seconds and quenched to 120°C at a cooling rate of 40°C/s. The quenched sheets were additional heat treated at 100°C for two hours after two minutes.

The aluminum alloy sheets obtained by these steps were subjected to measurements of tensile strength, yield strength, elongation, Lankford value r, yield strength after BH, and minimum bending radius in the directions at 0°, 45°, and 90° to the rolling direction by using the same methods as in Example 7 when seven days were passed after the final heat treatment. Anisotropy of Lankford values r was calculated and the presence or absence of ridging marks was evaluated. The results are shown in Table 30. As shown in Table 30, excellent properties were obtained in all the directions.

**TABLE 30**

| Angle to rolling direction | Tensile performance | | | Yield strength after BH (MPa) | n value | r value | Anisotropy of Lankford values r | Minimum inner bending radius (mm) | Occurrence of ridging mark |
|---|---|---|---|---|---|---|---|---|---|
| | Tensile strength (MFa) | Yield (MPa) | Elongation (%) | | | | | | |
| 0° | 241 | 128 | 23 | 227 | 0.26 | 0.66 | 0.61 | 0.0 | None |
| 45° | 225 | 112 | 37 | 205 | 0.29 | 0.18 | | 0.0 | None |
| 90° | 234 | 122 | 30 | 221 | 0.27 | 0.92 | | 0.0 | None |

### Example 10

Aluminum alloys having compositions shown in Table 31 were cast by using a DC casting method. The resulting ingots were homogenized at 550°C for six hours and cooled to 200°C at a cooling rate of 450°C/h. The ingots were then cooled to room temperature, heated to 420°C, and hot-rolled to a thickness of 4.5 mm. The hot rolling finish temperature was 250°C.

The hot-rolled products were cold-rolled to obtain sheets with a thickness of 1.0mm. The cold-rolled sheets were subjected to a solution heat treatment at 540°C for 20 seconds and quenched to 120°C at a cooling rate of 30°C/s. The sheets were additional heat treated at 100°C for three hours after three minutes.

The aluminum alloy sheets were subjected to a tensile test when 10 days were passed after the final heat treatment. Bake hardenability (BH), intensity ratio (random ratio) of cube orientation, and bendability were evaluated according to the following methods. The results are shown in Table 32.

Intensity ratio of cube orientation: The intensity ratio of cube orientation was calculated by a series expansion method proposed by Bunge using an ODF analysis device in which the expansion order of even-numbered terms was 22 and the expansion order of odd-numbered terms was 19.

Bake hardenability (BH): Yield strength was measured after applying 2% tensile deformation and performing heat treatment at 170°C for 20 minutes. A test material having a yield strength of 200 MPa or more was accepted.

Bendability: A 180° bending test for measuring the minimum bending radius was performed after applying 15% tensile prestrain. A test material having a minimum inner bending radius of 0.2 mm or less was accepted.

**TABLE 31**

| Alloy | Composition (wt%) | | | | | | | | | | |
|---|---|---|---|---|---|---|---|---|---|---|---|
| | Si | Mg | Zn | Cu | Mn | Cr | V | Zr | Fe | Ti | B |
| 66 | 1.0 | 0.62 | - | - | - | - | - | - | 0.24 | 0.03 | 10 |
| 67 | 1.0 | 0.46 | - | 0.01 | 0.08 | - | - | - | 0.16 | 0.02 | 5 |
| 68 | 0.94 | 0.53 | 0.18 | 0.01 | 0.10 | - | - | - | 0.15 | 0.02 | 5 |
| 69 | 1.0 | 0.42 | 0.04 | 0.75 | 0.10 | - | - | - | 0.15 | 0.02 | 5 |
| 70 | 1.6 | 0.36 | - | - | - | 0.06 | - | - | 0.15 | 0.02 | 5 |
| 71 | 1.1 | 0.54 | 0.02 | - | 0.05 | - | 0.09 | - | 0.12 | 0.01 | 7 |
| 72 | 0.9 | 1.1 | 0.01 | 0.02 | 0.07 | - | - | 0.07 | 0.14 | 0.02 | 5 |

| | | | | | | | | | | | |
|---|---|---|---|---|---|---|---|---|---|---|---|
| Note: Unit for B is ppm. | | | | | | | | | | | |

**TABLE 32**

| Test material | Alloy | Tensile performance | | | Yield strength after BH (MPa) | Intensity ratio of cube orientation | Minimum inner bending radius (mm) |
|---|---|---|---|---|---|---|---|
| | | Tensile strength (MPa) | Yield strength (MPa) | Elongation (%) | | | |
| 108 | 66 | 244 | 130 | 31 | 208 | 63 | 0.1 |
| 109 | 67 | 238 | 123 | 31 | 207 | 82 | 0.0 |
| 110 | 68 | 239 | 128 | 31 | 212 | 57 | 0.1 |
| 111 | 69 | 263 | 125 | 30 | 222 | 38 | 0.2 |
| 112 | 70 | 252 | 147 | 31 | 226 | 44 | 0.2 |
| 113 | 71 | 241 | 134 | 30 | 221 | 78 | 0.1 |
| 114 | 72 | 253 | 136 | 30 | 228 | 27 | 0.2 |

As shown in Table 32, test materials Nos. 108 to 114 according to The present invention excelled in strength and BH, had an intensity ratio of cube orientation of more than 20, and showed excellent minimum bending properties. Bendability after natural aging for four months was measured. As a result, the test materials of all the alloys had a minimum bending radius of 0.4 or less although the yield strength exceeded 160 MPa.

### Comparative Example 9

Aluminum alloys having compositions shown in Table 33 were cast by using a DC casting method. The resulting ingots were treated by the same steps as in Example 10. Tensile performance, bake hardenability (BH), intensity ratio of cube orientation, and bendability of the aluminum alloy sheets were evaluated according to the same methods as in Example 10 when 10 days were passed after the final heat treatment. The results are shown in Table 34.

**TABLE 33**

| Alloy | Composition (wt%) | | | | | | | | | | |
|---|---|---|---|---|---|---|---|---|---|---|---|
| | Si | Mg | Zn | Cu | Mn | Cr | V | Zr | Fe | Ti | B |
| 73 | 0.37 | 0.62 | - | 0.01 | 0.06 | 0.01 | - | - | 0.22 | 0.02 | 5 |
| 74 | 2.4 | 0.61 | - | 0.01 | 0.06 | - | - | - | 0.17 | 0.02 | 5 |
| 75 | 1.1 | 0.13 | - | 0.01 | - | 0.05 | - | - | 0.14 | 0.02 | 5 |
| 76 | 0.7 | 1.8 | 0.1 | 0.01 | - | 0.05 | - | - | 0.14 | 0.02 | 5 |
| 77 | 1.7 | 0.46 | - | 1.5 | - | - | - | 0.12 | 0.17 | 0.02 | 5 |
| 78 | 1.1 | 0.55 | - | 0.02 | 1.3 | - | - | - | 0.14 | 0.02 | 5 |
| 79 | 1.1 | 0.54 | - | 0.03 | - | 0.4 | - | - | 0.17 | 0.02 | 5 |
| 80 | 1.1 | 0.47 | - | 0.02 | - | 0.01 | 0.4 | - | 0.24 | 0.02 | 5 |
| 81 | 1.1 | 0.63 | - | 0.01 | - | - | - | 0.3 | 0.13 | 0.02 | 5 |

| | | | | | | | | | | | |
|---|---|---|---|---|---|---|---|---|---|---|---|
| Note: Unit for B is ppm. | | | | | | | | | | | |

**TABLE 34**

| Test material | Alloy | Tensile performance | | | Yield strength after BH (MPa) | Intensity ratio of cube orientation | Minimum inner bending radius (mm) |
|---|---|---|---|---|---|---|---|
| | | Tensile strength (MFa) | Yield strength (MPa) | Elongation (%) | | | |
| 115 | 73 | 148 | 79 | 30 | 119 | 51 | 0.0 |
| 116 | 74 | 261 | 147 | 31 | 228 | 16 | 0.6 |
| 117 | 75 | 155 | 75 | 29 | 127 | 66 | 0.0 |
| 118 | 76 | 270 | 149 | 29 | 283 | 14 | 0.6 |
| 119 | 77 | 281 | 145 | 29 | 244 | 8 | 0.7 |
| 120 | 78 | 251 | 140 | 29 | 228 | 14 | 0.6 |
| 121 | 79 | 243 | 132 | 27 | 220 | 15 | 0.6 |
| 122 | 80 | 236 | 133 | 29 | 218 | 12 | 0.6 |
| 123 | 81 | 238 | 139 | 29 | 222 | 17 | 0.7 |

As shown in Table 34, test material No. 115 and test material No. 117 had low strength and insufficient BH due to low Si content and low Mg content, respectively. Test material No. 116 and test material No. 118 showed high strength since (0.7Si% + Mg%) exceeded 2.2% due to high Si content and high Mg content, respectively. As a result, the degree of integration of cube orientation was decreased, whereby bendability was insufficient.

The degree of integration of cube orientation was decreased in test materials Nos. 119 to 123 due to high Cu content, high Mn content, high Cr content, high V content, and high Zr content, respectively, whereby bendability was insufficient.

### Example 11 and Comparative Example 10

The alloy No. 67 shown in Table 31 was cast by using a DC casting method. The resulting ingots were homogenized at 550°C for five hours and cooled to 250°C at a cooling rate shown in Table 35. The ingots were heated to a temperature shown in Table 35 and hot-rolled to a thickness of 4.4 mm. The hot rolling finish temperature was 250°C. The hot-rolled products were cold-rolled to obtain sheets with a thickness of 1.0 mm. Annealing process was performed at 400°C for two hours after hot rolling under a condition "t".

The sheets were subjected to a solution heat treatment at 550°C for five seconds and quenched to 120°C at a cooling rate of 3C1°C/s. The quenched sheets were additional heat treated at 100°c for three hours after three minutes. Tensile performance, BH, intensity ratio of cube orientation, and bendability of the aluminum alloy sheets obtained by these steps were evaluated according to the same methods as in Example 10.

For the evaluation of ridging marks, tensile specimens were collected in the direction at 90° to the rolling direction and subjected to 10% tensile deformation and electrodeposition coating. The presence or absence of ridging marks was then evaluated.

The results are shown in Table 36.

**TABLE 35**

| Condition | Cooling rate after homogenization (°C/h) | Hot rolling start temperature (°C) |
|---|---|---|
| k | 550 | 420 |
| l | 200 | 430 |
| m | 3500 | 410 |
| n | 500 | 470 |
| o | 450 | 350 |
| p | 360 | 540 |
| q | 2000 | 520 |
| r | 50 | 410 |
| s | 25 | 530 |
| t | 500 | 420 |

**TABLE 36**

| Test material | Condition | Tensile performance | | | Yield strength after BH (MPa) | Intensity ratio of cube orientation | Minimum inner bending radius (mm) | Occurren ce of ridging mark |
|---|---|---|---|---|---|---|---|---|
| | | Tensile strength (MPa) | Yield strength (MPa) | Elongation (%) | | | | |
| 124 | k | 232 | 122 | 29 | 213 | 77 | 0.0 | None |
| 125 | l | 224 | 120 | 31 | 206 | 85 | 0.0 | None |
| 126 | m | 232 | 131 | 30 | 227 | 73 | 0.1 | None |
| 127 | n | 241 | 131 | 31 | 232 | 70 | 0.1 | None |
| 128 | o | 225 | 123 | 31 | 220 | 83 | 0.0 | None |
| 129 | p | 235 | 126 | 30 | 224 | 35 | 0.3 | Observed |
| 130 | q | 230 | 126 | 28 | 218 | 28 | 0.3 | Observed |
| 131 | r | 214 | 109 | 30 | 190 | 11 | 0.5 | None |
| 132 | s | 233 | 123 | 30 | 213 | 7 | 0.6 | Observed |
| 133 | t | 226 | 118 | 30 | 208 | 15 | 0.4 | None |

As shown in Table 36, test materials Nos. 124 to 128 according to The present invention excelled in strength and BH, had an intensity ratio of cube orientation of more than 20, and showed excellent minimum bending properties.

On the contrary, ridging marks occurred in test materials Nos. 129 and 130 due to a high hot rolling temperature. Test material No. 131 had a small degree of integration of cube orientation due to a low cooling rate after homogenization, whereby bendability was insufficient. Ridging marks occurred in test material No. 132 due to a high hot rolling temperature and a low cooling rate after homogenization. Moreover, the test material No. 132 had a small degree of integration of cube orientation, whereby bendability was insufficient. Test material No. 133 had a small degree of integration of cube orientation since process annealing was performed, whereby bendability was insufficient.

### INDUSTRIAL APPLICABILITY

According to The present invention , an aluminum alloy sheet having excellent bendability which allows flat hemming, excellent bake hardenability, and excellent corrosion resistance, and a method for producing the same can be provided. The aluminum alloy sheet is suitably used as a lightweight automotive member having a complicated shape which is subjected to hemming, such as an automotive hood, trunk lid, and door.

## Claims

1. An aluminum alloy sheet with excellent formabiltity and paint bake hardenability, which comprises in weight %
a) 0.5 - 2.0% of Si and
b) 0.2 - 1.5 % of Mg as major alloy components,
c) with 0.7 Si % + Mg % ≤ 2.2 %
d) and Si % - 0.58 Mg % ≥ 0.1 % being satisfied,
e) optionally comprising at least one of
up to 0.5 % Zn,
up to 1.0%ofCu,
up to 1.0 % of Mn,
up to 0.3 % of Cr,
up to 0.2 % of V,
up to 0.2 % of Zr,
up to 0.1 % of Ti and
up to 50 ppm of B,
f) and the balance consisting of A1 and impurities,
g) in which an anisotropy of Lankford values is more than 0.4.

2. A method for producing the aluminum alloy sheet with excellent formability and paint bake hardenability according to claim 1, the method comprising
a) homogenizing an ingot of an aluminum alloy having the composition defined in claim 1 at a temperature of 450° C or more,
b) cooling the ingot to a temperature of less than 350°C at a cooling rate of 100°C/h or more,
c) heating the ingot to a temperature of 300-500°C and starting hot rolling of the ingot,
d) cold rolling the hot-rolled product,
e) and subjecting the cold-rolled product to a solution heat treatment at a temperature of 450°C or more,
f) and quenching.

3. A method for producing the aluminum alloy sheet with excellent formability and paint bake hardenability according to claim 1, the method comprising
a) homogenizing an ingot of an aluminum alloy having the composition defined in claim 1 at a temperature of 450°C or more,
b1) cooling the ingot to a temperature of less than 350°C at a cooling rate of 100°C /h or more,
b2) cooling the ingot to room temperature,
c) heating the ingot to a temperature of 300-500°C and starting hot rolling of the ingot,
d) cold rolling the hot-rolled product,
e) and subjecting the cold-rolled product to a solution heat treatment at a temperature of 450°C or more,
f) and quenching.

4. A method for producing the aluminum alloy sheet with excellent formability and paint bake hardenability according to any one of claims 2 and 3, wherein the hot rolling is finished at a temperature of 300°C or less.

5. A method for producing the aluminum alloy sheet with excellent formability and paint bake hardenability according to any one of claims 2 to 4, comprising quenching the solution-treated product to 120°C at a cooling rate of 5°C /s or more, and subjecting the quenched product to a heat treatment at a temperature of 40-120° C for 50 hours or less within 60 minutes after the quenching.

6. A method for producing the aluminum alloy sheet with excellent formability and paint bake hardenability according to claim 5, comprising subjecting the heat-treated product to a reversion treatment at a temperature of 170-230° C for 60 seconds or less within seven days after the heat treatment.

## Patentansprüche

1. Blech aus einer Aluminiumlegierung mit ausgezeichneten Umformbarkeitseigenschaften und Paint-Bake-Aushärtbarkeitseigenschaften, welches folgende Zusammensetzung in Gewichtsprozent verfüllt:
a) 0,5 bis 2,0% Si und
b) 0,2 bis 1,5% Mg als Hauptlegierungsbestandteile,
c) mit 0,7% Si + Mg% ≤ 2,2%,
d) und Si% - 0,58 Mg ≥0,1%,
e) optional aufweisend wenigstens eines von
bis zu 0,5% Zn,
bis zu 1,0% Cu,
bis zu 1,0% Mn,
bis zu 0,3% Cr,
bis zu 0,2% V,
bis zu 0,2% Zr,
bis zu 0,1 % Ti und
bis zu 50 ppm B,
f) und der Rest bestehend aus Al und Verunreinigungen,
g) in denen eine Anisotropie der Lankford Werte mehr als 0,4 beträgt.

2. Ein Verfahren zur Produktion des Blechs aus einer Aluminiumlegierung mit ausgezeichneten Umformbarkeitseigenschaften und Paint-Bake-Aushärtbarkeitseigenschaften nach Anspruch 1, wobei das Verfahren umfasst
a) die Homogenisierung eines Ingots aus einer Aluminiumlegierung, die die in Anspruch 1 definierte Zusammensetzung aufweist, bei einer Temperatur von 450°C oder mehr,
b) das Abkühlen des Ingots auf eine Temperatur unter 350°C mit einer Abkühlungsgeschwindigkeit von 100°C/h oder mehr,
c) Erwärmen des Ingots auf eine Temperatur von 300 bis 500°C und Beginnen des Heißrollen des Ingots,
d) Kaltrollen des heißgerollten Produkts,
e) und das Unterziehen des kaltgerollten Produkts einer Wärmebehandlung mittels einer Lösung bei einer Temperatur von 450°C oder mehr,
f) und Abschrecken.

3. Ein Verfahren zur Produktion des Blechs aus einer Aluminiumlegierung mit ausgezeichneten Umformbarkeitseigenschaften und Paint-Bake-Aushärtbarkeitseingenschaften nach Anspruch 1, wobei das Verfahren umfasst
a) die Homogenisierung eines Ingots aus einer Aluminiumlegierung, die die in Anspruch 1 definierte Zusammensetzung aufweist, bei einer Temperatur von 450°C oder mehr,
b1) das Abkühlen des Ingots auf eine Temperatur unter 350°C mit einer Abkühlungsgeschwindigkeit von 100°C/h oder mehr,
b2) das Abkühlen des Ingots auf Raumtemperatur,
c) Erwärmen des Ingots auf eine Temperatur von 300 bis 500°C und Beginnen des Heißrollens des Ingots,
d) Kaltrollen des heißgerollten Produkts,
e) und das Unterziehen des kaltgerollten Produkts einer Wärmebehandlung mittels einer Lösung bei einer Temperatur von 450°C oder mehr,
f) und Abschrecken.

4. Ein Verfahren zur Produktion des Blechs aus einer Aluminiumlegierung mit ausgezeichneten Umformbarkeitseigenschaften und Paint-Bake-Aushärtbarkeitseingenschaften nach einem der Ansprüche 2 oder 3, wobei das Heißrollen bei einer Temperatur von 300°C oder weniger beendet ist.

5. Eine Verfahren zur Produktion des Blechs aus einer Aluminiumlegierung mit ausgezeichneten Umformbarkeitseigenschaften und Paint-Bake-Aushärtbarkeitseingenschaften nach einem der Ansprüche 2 bis 4, umfassend das Abschrecken des mittels der Lösung behandelten Produkts auf 120°C mit einer Abkühlungsrate von 5°C/sek oder mehr, und das Unterziehen des abgeschreckten Produkts einer Wärmebehandlung bei einer Temperatur von 40 bis 120°C für 50 Stunden oder weniger innerhalb von 60 Minuten nach dem Abschrecken.

6. Das Verfahren zur Produktion des Blechs aus einer Aluminiumlegierung mit ausgezeichneten Umformbarkeitseigenschaften und Paint-Bake-Aushärtbarkeitseingenschaften nach Anspruch 5, umfassend das Unterziehen des wärmebehandelten Produkts einer Reversionsbehandlung bei einer Temperatur von 170 bis 230°C für 60 Sekunden oder weniger innerhalb von sieben Tagen nach der Wärmebehandlung.

## Revendications

1. Feuille d'alliage d'aluminium dotée d'une excellente formabilité et d'une excellente trempabilité par cuisson de peinture, qui comprend en % en poids
a) 0,5-2,0 % de Si et
b) 0,2-1,5 % de Mg comme composants principaux de l'alliage.
c) avec 0,7 % de Si + Mg ≤ 2,2 %
d) et % de Si - 0,58 % ≥ 0,1 % étant satisfaites,
e) comprenant en option au moins un de : jusqu'à 0,5 % Zn,
jusqu'à 1,0 % de Cu,
jusqu'à 1,0 % de Mn,
jusqu'à 0,3 % de Cr,
jusqu'à 0,2 % de V,
jusqu'à 0,2 % de Zr,
jusqu'à 0,1 % de Ti,
et jusqu'à 50 ppm de B,
f) et le reste étant constitué d'Al et des impuretés,
g) dans laquelle les valeurs d'anisotropie de Lankford sont supérieures à 0,4.

2. Procédé de production de la feuille d'alliage d'aluminium dotée d'une excellente formabilité et d'une excellente trempabilité par cuisson de peinture suivant la revendication 1, le procédé comprenant
a) l'homogénéisation d'un lingot d'un alliage d'aluminium ayant la composition définie dans la revendication 1 à une température de 450 °C ou plus,
b) le refroidissement du lingot à une température de moins de 350 °C à une vitesse de refroidissement de 100 °C/h ou plus,
c) le chauffage du lingot à une température de 300-500 °C et le démarrage du laminage à chaud du lingot,
d) le laminage à froid du produit laminé à chaud,
e) et la soumission du produit laminé à froid à un traitement thermique de mise en solution à une température de 450°C ou plus,
f) et une trempe.

3. Procédé de production de la feuille d'alliage d'aluminium dotée d'une excellente formabilité et d'une excellente trempabilité par cuisson de peinture suivant la revendication 1, le procédé comprenant
a) l'homogénéisation d'un lingot d'un alliage d'aluminium ayant la composition définie dans la revendication 1 à une température de 450 °C ou plus,
b1) le refroidissement du lingot à une température de moins de 350 °C à une vitesse de refroidissement de 100 °C/h ou plus,
b2) le refroidissement du lingot à température ambiante,
c) le chauffage du lingot à une température de 300-500 °C et le démarrage du laminage à chaud du lingot,
d) le laminage à froid du produit laminé à chaud,
e) et la soumission du produit laminé à froid à un traitement thermique de mise en solution à une température de 450°C ou plus,
f) et une trempe.

4. Procédé de production de la feuille d'alliage d'aluminium dotée d'une excellente formabilité et d'une excellente trempabilité par cuisson de peinture suivant l'une des revendications 2 et 3, dans lequel le laminage à chaud est terminé à une température de 300 °C ou moins.

5. Procédé de production de la feuille d'alliage d'aluminium dotée d'une excellente formabilité et d'une excellente trempabilité par cuisson de peinture suivant l'une des revendications 2 à 4, comprenant la trempe du produit traité pour mise en solution à 120 °C à une vitesse de refroidissement de 5 °C/s ou plus, et la soumission du produit trempé à un traitement thermique à une température de 40-120 °C pendant 50 heures ou moins dans les 60 minutes suivant la trempe.

6. Procédé de production de la feuille d'alliage d'aluminium dotée d'une excellente formabilité et d'une excellente trempabilité par cuisson de peinture suivant la revendication 5, comprenant la soumission du produit ayant subi le traitement thermique à un traitement de réversion à une température de 170-230 °C pendant 60 secondes ou moins dans les sept jours suivant le traitement thermique.
